# EUROPEAN PATENT APPLICATION

(11) **EP 4 621 830 A1**
(43) Date of publication of application: **24.09.2025**
(21) Application number: 25157755.7
(22) Date of filing: 13.02.2025
(51) Int. Cl.: H01L 21/48, H01L 23/15, H01L 23/498, H01L 23/538

(54) **MICROELECTRONIC ASSEMBLIES WITH SEALED LINERS FOR GLASS CORES**

(30) Priority: 16.02.2024 US 202418444431
(71) Applicant: Intel Corporation, Santa Clara, CA 95054 (US)
(72) Inventor: PIETAMBARAM, Srinivas Venkata Ramanuja, Chandler, 85249 (US); MANEPALLI, Rahul N., Chandler, 85249 (US)
(74) Representative: 2SPL Patentanwälte PartG mbB

(57) **Abstract**

A microelectronic assembly according to an embodiment of the present disclosure may include a glass core having a first face and a second face opposite the first face, and a TGV in the glass core, the TGV extending from the first face towards the second face and including a conductive material. The microelectronic assembly may further include an organic material in the TGV, between the conductive material and the glass core, wherein a modulus of the organic material is smaller than about 30 GPa, and an inorganic material over the organic material in the TGV, the inorganic material comprising silicon and nitrogen. In such a microelectronic assembly, the glass core, the conductive material, and the inorganic material may completely enclose the organic material to reduce or eliminate degradation (e.g., oxidation and/or crystallization) of the organic material.

## Description

### Background

For the past several decades, scaling of features in integrated circuits (ICs) has been a driving force behind an ever-growing semiconductor industry and emerging applications in fields such as big data, artificial intelligence, mobile communications, and autonomous driving. Scaling to smaller and smaller features enables increased densities of functional units on the limited real estate of semiconductor chips. For example, shrinking transistor size allows incorporation of an increased number of memory or logic devices on a chip, lending to the fabrication of products with increased capacity. The drive for the ever-increasing capacity, however, is not without issue. The necessity to optimize fabrication and performance of each component (e.g., of each transistor) is becoming increasingly significant.

Parallel to optimizations at the transistor level, advanced IC packaging landscape is rapidly evolving to accommodate performance expectations and requirements of shrinking transistor size. Multiple IC dies are now commonly coupled together in a multi-die IC package to integrate features or functionality and to facilitate connections to other components, such as package substrates. For example, IC packages may include an embedded multi-die interconnect bridge (EMIB) for coupling two or more IC dies.

Integration of multiple dies in a single IC package has tremendous benefits but adds additional complexities due to placing materials with different material properties in close proximity to one another. When an IC package undergoes multiple processing steps involving various temperatures and pressure loads, individual materials within the package may behave differently from one another, resulting in out of plane deformation of various layers, known as "package warpage." One way to address package warpage is to use stiffer cores to which different IC dies are attached. Recently, glass cores have been explored as alternatives to organic resin-based cores (e.g., cores based on using Ajinomoto Build-up Film(ABF)). Glass is considered more rigid than organic resin-based materials and has several advantages such as excellent thermal properties, low coefficient of thermal expansion (CTE), high electrical insulation, chemical resistance, optical transparency, and compatibility with advances semiconductor properties. However, a major challenge for widespread adoption of glass cores is the fact that glass is highly susceptible to damage due to mechanical and/or thermal stresses, e.g., damage due to stresses caused by through-glass vias (TGVs) filled with metals.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1 is a schematic side, cross-sectional view of one example microelectronic assembly, according to some embodiments of the present disclosure.
FIG. 2 is a schematic side, cross-sectional view of another example microelectronic assembly, according to some embodiments of the present disclosure.
FIG. 3 illustrates surfaces of a glass core from which TGV stress may initiate, according to some embodiments of the present disclosure.
FIGS. 4A-4C illustrate cross-sectional side views of example glass cores with sealed liners, according to some embodiments of the present disclosure.
FIG. 5 is a flow diagram of a first method of providing a glass core with a sealed liner, in accordance with some embodiments.
FIGS. 6A-6F provide cross-sectional side views at various stages in the fabrication of an example glass core with a sealed liner according to the method of FIG. 5, in accordance with some embodiments.
FIG. 7 is a flow diagram of a second method of providing a glass core with a sealed liner, in accordance with some embodiments.
FIGS. 8A-8C provide cross-sectional side views at various stages in the fabrication of an example glass core with a sealed liner according to the method of FIG. 7, in accordance with some embodiments.
FIG. 9 is a flow diagram of a third method of providing a glass core with a sealed liner, in accordance with some embodiments.
FIGS. 10A-10C provide cross-sectional side views at various stages in the fabrication of an example glass core with a sealed liner according to the method of FIG. 9, in accordance with some embodiments.
FIG. 11 is a top view of a wafer and dies that may be included in a microelectronic assembly with a glass core in accordance with any of the embodiments disclosed herein, according to some embodiments of the present disclosure.
FIG. 12 is a side, cross-sectional view of an IC device that may be included in a microelectronic assembly with a glass core in accordance with any of the embodiments disclosed herein, according to some embodiments of the present disclosure.
FIG. 13 is a side, cross-sectional view of an IC device assembly that may include a glass core in accordance with any of the embodiments disclosed herein, according to some embodiments of the present disclosure.
FIG. 14 is a block diagram of an example communication device that may include a microelectronic assembly with a glass core in accordance with any of the embodiments disclosed herein, according to some embodiments of the present disclosure.

### Detailed Description

As mentioned above, glass has properties that make it promising for integration in advanced IC packaging. When a glass core is included in a microelectronic assembly, it may be desirable to route electrical signals in and/or through the glass core. To that end, conductive vias may be provided in the glass core, such conductive vias commonly referred to as TGVs. TGVs may also support efficient thermal management by providing paths for heat dissipation from the active components to the package's external environment. In some implementations, TGVs may extend between the top and the bottom surfaces of a glass core, e.g., to provide electrical connectivity between electronic components such as dies and/or package substrates, coupled to the top and bottom surfaces of the glass core. In other implementations, TGVs may be blind vias that extend from the top/bottom surface of the glass core towards, but not reaching, the opposite surface, e.g., to provide electrical connectivity from a surface of the glass core to a conductive trace or an IC component embedded in the glass core.

Provision of TGVs in glass cores enables more compact and efficient designs for microelectronic assemblies. However, integration of TGVs in glass cores is not trivial. Conventionally, fabrication of TGVs includes forming openings for future TGVs, lining the openings with a seed material, and then depositing a conductive fill material into the lined openings. The seed material typically includes a low-resistivity metal such as copper that can be deposited in a thin layer on substantially non-conductive surfaces (e.g., sidewalls) of the openings in the glass core. The seed material is intended to provide conductive surfaces for uniform and controlled deposition of the conductive fill material in a subsequent deposition step, e.g., when the conductive fill material is deposited in the lined openings using a process such as electroplating. One challenge associated with integration of TGVs in glass cores arises from the differences in CTEs between materials that may be used for glass cores and metals of the seed material and of the conductive fill material deposited in the TGVs. CTE is a measure of how a material expands or contracts with changes in temperature and is typically defined as the fractional increase in length per unit rise in temperature, measured in, e.g., parts per million (ppm) per degrees Kelvin (K) or ppm/K. Glass materials that may be used for glass cores and metals have significantly different CTEs. Metals have relatively high CTEs, meaning that they may expand and contract significantly with changes in temperature. Glass materials, on the other hand, have much lower CTEs and are less responsive to temperature changes. For example, a CTE of glass is on the order of about 3.5 ppm/K, while a CTE of a metal such as copper is on the order of about 15 ppm/K. When a metal is in close contact with glass (e.g., a seed material or a conductive fill material within a TGV in the glass core), and the assembly is exposed to temperature variations such as heating or cooling, the metal will heat up or cool down much faster, and to a greater extent, than the glass. This leads to the generation of significant thermal stress at the interface between the two materials. The high thermal stress can exceed the strength of the glass, leading to the formation of cracks, which may then propagate and compromise the structural integrity of the glass. Even if cracks don't form immediately, the repeated thermal cycling can gradually weaken the glass surface, potentially leading to the development of surface flaws or micro-cracks. Prolonged exposure to CTE mismatch-induced stresses can cause gradual degradation of the glass, making it more prone to failure over time.

Embodiments of the present disclosure relate to various techniques, as well as to related devices and methods, for alleviating (e.g., mitigating or reducing) CTE mismatch-induced stresses caused by the proximity of conductive materials of TGVs to glass materials of the glass cores. As used herein, such stresses are referred to as "TGV stress." Embodiments of the present disclosure are based on recognition that including a liner material on sidewalls of TGVs, as a buffer layer between the glass core and conductive material(s) in the TGVs, may help reduce TGV stress because the liner material separates the glass and metals of the seed material and the conductive fill material deposited in the TGVs. In particular, selecting a liner material as a material having a relatively low modulus, e.g., having Young's modulus below about 30 gigapascal (GPa), may be particularly advantageous for reducing TGV stress. Embodiments of the present disclosure are further based on recognition that such liner materials may be compromised/degraded due to, e.g., oxidation or crystallization that can occur during the processes involved in glass core substrate manufacturing. For example, one type of materials that have relatively low modulus but may be susceptible to degradation due to, e.g., oxidation and/or crystallization, is parylene, where, as used herein, the name "parylene" refers to a group of polymers known as poly-para-xylylenes. Inventors of the present disclosure established that decoupling the conductive materials of TGVs from the glass sidewalls through a low-modulus liner material such as parylene can reduce TGV stress significantly, but one other issue that may arise is that of a cohesive failure of the liner material that may be attributed to degradation of the liner material due to, e.g., oxidation (e.g., degradation of the parylene films during open air copper anneal) or crystallization. Therefore, microelectronic assemblies described herein further include a sealant that can seal the liner material, thus reducing or eliminating oxidation and/or crystallization of the liner material. In context of the present disclosure, a liner material that has been sealed with a sealant may be referred to as a "sealed liner." In one aspect, a microelectronic assembly according to an embodiment of the present disclosure may include a glass core having a first face and a second face opposite the first face, and a TGV in the glass core, the TGV extending from the first face towards the second face and including a conductive material. The microelectronic assembly may further include an organic liner material in the TGV, between the conductive material and the glass core, wherein a modulus of the organic material is smaller than about 30 GPa, and a sealant provided as an inorganic material over the organic material in the TGV, the inorganic material comprising silicon and nitrogen. In such a microelectronic assembly, the glass core, the conductive material, and the inorganic material may completely enclose the organic material to reduce or eliminate degradation (e.g., oxidation and/or crystallization) of the organic material.

Integration of layers of different materials (e.g., multiple dies, redistribution layers, package substrates) in a single IC package or a microelectronic assembly is challenging due to package warpage, among others. Providing IC packages or microelectronic assemblies with glass cores having TGVs with sealed liners as described herein may help. Various ones of the embodiments disclosed herein may help achieve reliable integration of multiple layers of different materials within a single microelectronic assembly at a lower cost and/or with greater design flexibility, relative to conventional approaches. Various ones of the microelectronic assemblies disclosed herein may exhibit reduced warpage, relative to microelectronic assemblies without glass cores. The microelectronic assemblies disclosed herein may be particularly advantageous for small and low-profile applications in computers, tablets, industrial robots, and consumer electronics (e.g., wearable devices).

In the following detailed description, reference is made to the accompanying drawings that form a part hereof wherein like numerals designate like parts throughout, and in which is shown, by way of illustration, embodiments that may be practiced. It is to be understood that other embodiments may be utilized, and structural or logical changes may be made, without departing from the scope of the present disclosure. Therefore, the following detailed description is not to be taken in a limiting sense.

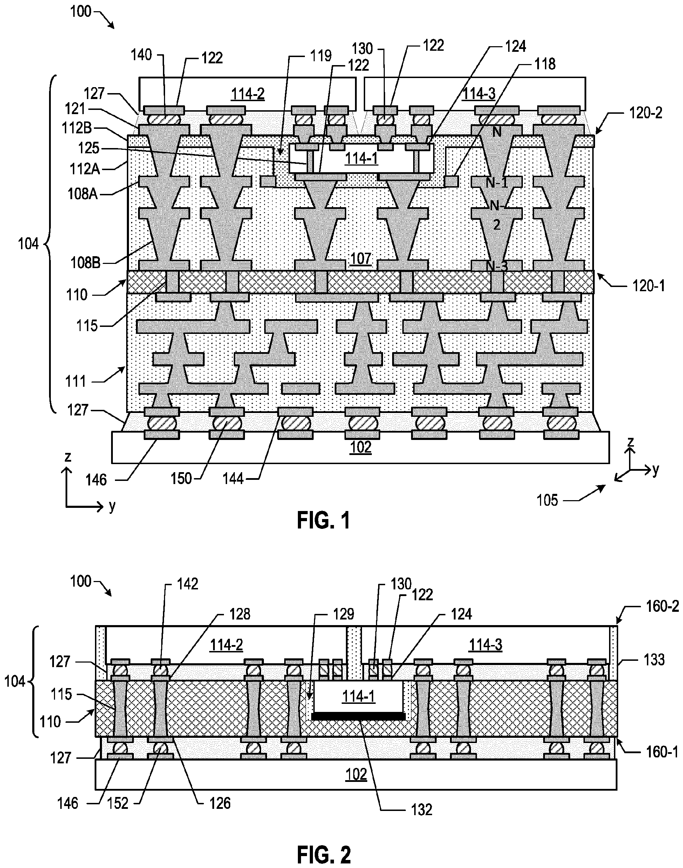

Any of the features discussed with reference to any of accompanying drawings herein may be combined with any other features to form a microelectronic assembly 100, a glass core 110, an IC device 1600, an IC device assembly 1700, or a communication device 1800, as appropriate. For convenience, the phrase "dies 114" may be used to refer to a collection of dies 114-1, 114-2, and so on, etc. A number of elements of the drawings with same reference numerals may be shared between different drawings; for ease of discussion, a description of these elements provided with respect to one of the drawings is not repeated for the other drawings, and these elements may take the form of any of the embodiments disclosed herein. To not clutter the drawings, if multiple instances of certain elements are illustrated, only some of the elements may be labeled with a reference numeral (e.g., a plurality of conductive contacts 122 are shown in FIG. 1 but only one of the them is labeled with a reference numeral). Also to not clutter the drawings, not all reference numerals shown in one of the drawings are shown in other similar drawings.

The drawings are not necessarily to scale. Although many of the drawings illustrate rectilinear structures with flat walls and right-angle corners, this is simply for ease of illustration and may not reflect real-life process limitations which may cause various features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers. There may be other defects not listed here but that are common within the field of semiconductor device fabrication and packaging. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of a glass core with one or more sealed liners as described herein.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). When used to describe a range of dimensions, the phrase "between X and Y" represents a range that includes X and Y. When used to describe a location of an element, the phrase "between X and Y" represents a region that is spatially between element X and element Y. The terms "substantially," "close," "approximately," "near," and "about," generally refer to being within +/- 20%, e.g., within +/- 5% or within +/- 2%, of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 10%, e.g., within +/- 5% or within +/- 2%, of the exact orientation.

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. As used herein, the terms "package" and "IC package" are synonymous, as are the terms "die" and "IC die." Furthermore, the terms "chip," "chiplet," "die," and "IC die" may be used interchangeably herein.

Although certain elements may be referred to in the singular herein, such elements may include multiple sub-elements. For example, "a dielectric material" may include one or more dielectric materials or "an insulator material" may include one or more insulator materials. The terms "oxide," "carbide," "nitride," etc. refer to compounds containing, respectively, oxygen, carbon, nitrogen, etc. The term "high-k dielectric" refers to a material having a higher dielectric constant than silicon oxide, while the term "low-k dielectric" refers to a material having a lower dielectric constant than silicon oxide. The term "insulating" and variations thereof (e.g., "insulative" or "insulator") means "electrically insulating," the term "conducting" and variations thereof (e.g., "conductive" or "conductor") means "electrically conducting," unless otherwise specified. With reference to optical signals and/or devices, components and elements that operate on or using optical signals, the term "conducting" can also mean "optically conducting." The term "insulating material" refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon and alumina or a combination thereof. They may include dielectric materials, high polarizability materials, and/or piezoelectric materials. They may be transparent or opaque without departing from the scope of the present disclosure. Further examples of insulating materials are underfills and molds or mold-like materials used in packaging applications, including for example, materials used in organic interposers, package supports and other such components.

FIG. 1 is a schematic side, cross-sectional view of one example microelectronic assembly 100 in which a glass core with one or more sealer liners as described herein may be implemented, according to some embodiments of the present disclosure. The microelectronic assembly 100 may include a substrate 107 with a double-sided bridge die 114-1 in a cavity 119 in the substrate 107, the die 114-1 may be electrically coupled to a conductive pathway, e.g., a conductive trace 108A or a conductive via 108B, in a metal layer N-1 of the substrate 107 that is beneath a bottom of the cavity 119. The substrate 107 may include a dielectric material 112 (e.g., a first dielectric material layer 112A and a second dielectric material layer 112B, as shown, together referred to as "one or more layers of the dielectric material 112") and a conductive material 108 arranged in the one or more layers of the dielectric material 112 to provide conductive pathways (e.g., conductive traces 108A and conductive vias 108B) through the substrate 107, as well as to provide conductive pads and contacts. The substrate 107 may include a first surface 120-1 and an opposing second surface 120-2. The die 114-1 may be surrounded by the dielectric material 112 of the substrate 107. The die 114-1 may include a bottom face (e.g., the surface facing towards the first surface 120-1) with first conductive contacts 122, an opposing top face (e.g., the surface facing towards the second surface 120-2) with second conductive contacts 124, and through-silicon vias (TSVs) 125 coupling respective first and second conductive contacts 122, 124. In some embodiments, a pitch of the first conductive contacts 122 on the first die 114-1 maybe between 25 microns and 250 microns. As used herein, pitch is measured center-to-center (e.g., from a center of a conductive contact to a center of an adjacent conductive contact). In some embodiments, a pitch of the second conductive contacts 124 on the first die 114-1 maybe between 25 microns and 100 microns. The dies 114-2, 114-3 may include a set of conductive contacts 122 on the bottom face of the die (e.g., the surface facing towards the first surface 120-1). The die 114 may include other conductive pathways (e.g., including lines and vias) and/or to other circuitry (not shown) coupled to the respective conductive contacts (e.g., conductive contacts 122, 124) on the surface of the die 114. As used herein, the terms "die," "microelectronic component," and similar variations may be used interchangeably. As used herein, the terms "interconnect component," "bridge die," and similar variations may be used interchangeably. The bridge die 114-1 may be electrically coupled to dies 114-2, 114-3 by die-to-die (DTD) interconnects 130 at a second surface 120-2. In particular, conductive contacts 124 on a top face of the die 114-1 may be coupled to conductive contacts 122 on a bottom face of dies 114-2, 114-3 by conductive vias 108B through the second dielectric material layer 112B.

As used herein, a "conductive contact" may refer to a portion of conductive material (e.g., metal) serving as an electrical interface between different components (e.g., part of a conductive interconnect); conductive contacts may be recessed in, flush with, or extending away (e.g., having a pillar shape) from a surface of a component, and may take any suitable form (e.g., a conductive pad or socket, or portion of a conductive line or via). In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are comprised in the term "interconnect." The nature of the interconnect being described is to be understood herein with reference to the signal medium associated therewith. Thus, when used with reference to an electronic device, such as an IC that operates using electrical signals, the term "interconnect" describes any element formed of a conductive material for providing electrical connectivity to one or more elements associated with the IC or/and between various such elements. In such cases, the term "interconnect" may refer to both conductive traces (also sometimes referred to as "metal traces," "lines," "metal lines," "wires," "metal wires," "trenches," or "metal trenches") and conductive vias (also sometimes referred to as "vias" or "metal vias"). Sometimes, conductive traces and vias may be referred to as "metal traces" and "metal vias", respectively, to highlight the fact that these elements include conductive materials such as metals. Likewise, when used with reference to a device that operates on optical signals as well, such as a photonic IC (PIC), "interconnect" may also describe any element formed of a material that is optically conductive for providing optical connectivity to one or more elements associated with the PIC. In such cases, the term "interconnect" may refer to optical waveguides (e.g., structures that guide and confine light waves), including optical fiber, optical splitters, optical combiners, optical couplers, and optical vias.

The die 114 disclosed herein may include an insulating material (e.g., a dielectric material formed in multiple layers, as known in the art) and multiple conductive pathways formed through the insulating material. In some embodiments, the insulating material of a die 114 may include a dielectric material, such as silicon dioxide, silicon nitride, oxynitride, polyimide materials, glass reinforced epoxy matrix materials, or a low-k or ultra low-k dielectric (e.g., carbon-doped dielectrics, fluorine-doped dielectrics, porous dielectrics, organic polymeric dielectrics, photo-imageable dielectrics, and/or benzocyclobutene-based polymers). In some embodiments, the insulating material of a die 114 may include a semiconductor material, such as silicon, germanium, or a III-V material (e.g., gallium nitride), and one or more additional materials. For example, an insulating material may include silicon oxide or silicon nitride. The conductive pathways in a die 114 may include conductive traces and/or conductive vias, and may connect any of the conductive contacts in the die 114 in any suitable manner (e.g., connecting multiple conductive contacts on a same surface or on different surfaces of the die 114). Example structures that may be included in the dies 114 disclosed herein are discussed below with reference to the IC device 1600. The conductive pathways in the dies 114 may be bordered by liner materials, such as adhesion liners and/or barrier liners, as suitable. In some embodiments, the die 114 is a wafer. In some embodiments, the die 114 is a monolithic silicon, a fan-out or fan-in package die, or a die stack (e.g., wafer stacked, die stacked, or multi-layer die stacked).

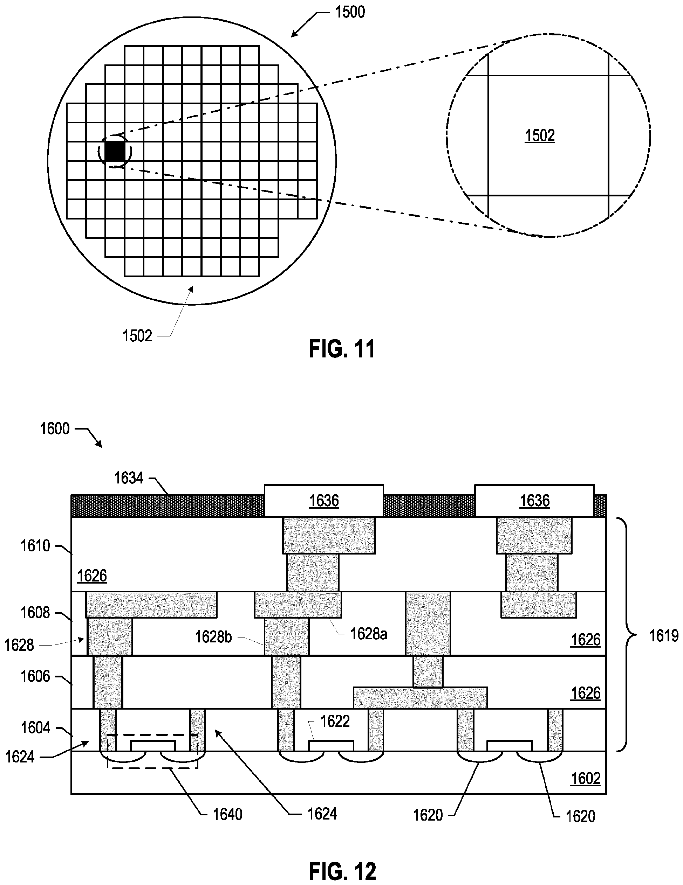

In some embodiments, the die 114 may include conductive pathways to route power, ground, and/or signals to/from other dies 114 included in the microelectronic assembly 100. For example, the die 114-1 may include TSVs 125, including a conductive via, such as a metal via, isolated from the surrounding silicon or other semiconductor material by a barrier oxide),or other conductive pathways through which power, ground, and/or signals may be transmitted between the package substrate 102 and one or more dies 114 "on top" of the die 114-1 (e.g., in the embodiment of FIG. 1, the dies 114-2 and/or 114-3). In some embodiments, the die 114-1 may not route power and/or ground to the dies 114-2 and 114-3; instead, the dies 114-2, 114-3 may couple directly to power and/or ground lines in the package substrate 102 by substrate-to-package substrate (STPS) interconnects 150, conductive pathways provided by the conductive material 108 in the substrate 107, and die-to-substrate (DTS) interconnects 140. In some embodiments, the die 114-1 may be thicker than the dies 114-2, 114-3. In some embodiments, the die 114-1 may be a memory device or a high frequency serializer and deserializer (SerDes), such as a Peripheral Component Interconnect (PCI) express. In some embodiments, the die 114-1 may be a processing die, a radio frequency chip, a power converter, a network processor, a workload accelerator, a voltage regulator die, or a security encryptor. In some embodiments, the die 114-2 and/or the die 114-3 may be a processing die, a radio frequency chip, a power converter, a network processor, a workload accelerator, a voltage regulator die, or a security encryptor. In some embodiments, the die 114 may be as described below with reference to the die 1502 of FIG. 11.

The dielectric material 112 of the substrate 107 may be formed in layers (e.g., at least a first dielectric material layer 112A and a second dielectric material layer 112B). In some embodiments, the dielectric material 112 may include an organic material, such as an organic build-up film. In some embodiments, the dielectric material 112 may include a ceramic, an epoxy film having filler particles therein, glass, an inorganic material, or combinations of organic and inorganic materials, for example. In some embodiments, the conductive material 108 may include a metal (e.g., copper). In some embodiments, the substrate 107 may include layers of dielectric material 112/conductive material 108, with lines/traces/pads/contacts (e.g., conductive traces 108A) of conductive material 108 in one layer electrically coupled to lines/traces/pads/contacts (e.g., conductive traces 108A) of conductive material 108 in an adjacent layer by vias (e.g., 108B) of the conductive material 108 extending through the dielectric material 112. Conductive traces 108A may be referred to herein as "conductive lines," "conductive elements," "conductive pads," or "conductive contacts." A substrate 107 including such layers may be formed using a printed circuit board (PCB) fabrication technique, for example.

An individual layer of dielectric material 112 (e.g., a first dielectric material layer 112A) may include a cavity 119 and the bridge die 114-1 may be at least partially nested in the cavity 119. The bridge die 114-1 may be surrounded by (e.g., embedded in) a next individual layer of dielectric material 112 (e.g., a second dielectric material layer 112B). In some embodiments, a cavity 119 is tapered, narrowing towards a bottom face of the cavity 119 (e.g., the surface towards the first surface 120-1 of the substrate 107). A cavity 119 may be indicated by a seam between the dielectric material 112A and the dielectric material 112B. As shown in FIG. 1, in cases where the bridge die 114-1 is partially nested in a cavity 119, a top face of the bridge die 114-1 may extend above a top face of dielectric material 112A. In cases where the bridge die 114-1 is fully nested in a cavity 119 (not shown), a top face of the bridge die 114-1 may be planar with or below a top face of dielectric material 112A.

A substrate 107 may include N layers of conductive material 108, where N is an integer greater than or equal to one. In FIG. 1, the layers are labeled in descending order from the second surface 120-2 (e.g., the top face) of the substrate 107 (e.g., layer N, layer N-1, layer N-2, etc.). In particular, as shown in FIG. 1, a substrate 107 may include four metal layers (e.g., N, N-1, N-2, and N-3). The N metal layer may include conductive contacts 121 at the second surface 120-2 of the substrate 107 that are coupled to conductive contacts 122 at bottom faces of the die 114-2, 114-3 by DTS interconnects 140. The N-2 metal layer may include conductive traces 108A having a top face (e.g., the surface facing towards the second surface 120-2 of the substrate 107), an opposing bottom face (e.g., the surface facing towards the first surface 120-1 of the substrate 107), and lateral surfaces extending between the top and bottom faces of the conductive traces 108A. A substrate 107 may further include an N-1 metal layer above the N-2 metal layer and below the N metal layer, where a portion of the N-1 metal layer includes a metal ring 118 exposed at a perimeter of the bottom of the cavity 119. The metal ring 118 may be coplanar with the conductive traces 108A of the N-1 metal layer and may be proximate to the edges of the cavity 119, as shown.

Although a particular number and arrangement of layers of dielectric material 112/conductive material 108 are shown in various ones of the accompanying figures, these particular numbers and arrangements are simply illustrative, and any desired number and arrangement of dielectric material 112/conductive material 108 may be used. Further, although a particular number of layers are shown in the substrate 107 (e.g., four layers), these layers may represent only a portion of the substrate 107, for example, further layers may be present (e.g., layers N-4, N-5, N-6, etc.).

As shown in FIG. 1, the substrate 107 may further include a glass core 110 with TGVs 115 and further layers 111 may be present below the glass core 110 and coupled to a package substrate 102 by interconnects 150. Any of the TGVs 115 may be a conductive via with a sealed liner as described herein. As used herein, the term "glass core" refers to a layer (e.g., a glass layer) or a structure (e.g., a portion of a glass layer) of any glass material such as quartz, silica, fused silica, silicate glass (e.g., borosilicate, aluminosilicate, alumino-borosilicate), soda-lime glass, soda-lime silica, borofloat glass, lead borate glass, photosensitive glass, non-photosensitive glass, or ceramic glass. In particular, the glass core 110 may be bulk glass or a solid volume/layer of glass, as opposed to, e.g., materials that may include particles of glass, such as glass fiber reinforced polymers (e.g., substrates/boards constructed of glass fibers and an epoxy binder). Such glass materials are typically non-crystalline, often transparent, amorphous solids. In some embodiments, the glass core 110 may be an amorphous solid glass layer. In some embodiments, the glass core 110 may include a material comprising silicon and oxygen, as well as any one or more of aluminum, boron, magnesium, calcium, barium, tin, sodium, potassium, strontium, phosphorus, zirconium, lithium, titanium, and zinc. In some embodiments, the glass core 110 may include a material, e.g., any of the materials described above, with a weight percentage of silicon being at least about 0.5%, e.g., between about 0.5% and 50%, between about 1% and 48%, or at least about 23%. For example, if the glass core 110 is fused silica, the weight percentage of silicon may be about 47%. In some embodiments, the glass core 110 may include a material having at least 23% silicon and/or at least 26% oxygen by weight, and, in some further embodiments, the glass core 110 may further include at least 5% aluminum by weight. In some embodiments, the glass core 110 may include any of the materials described above and may further include one or more additives such as Al₂O₃, B₂O₃, MgO, CaO, SrO, BaO, SnO₂, Na₂O, K₂O, SrO, P₂O₃, ZrO₂, Li₂O, Ti, and Zn. In some embodiments, the glass core 110 may be a layer of glass that does not include an organic adhesive or an organic material. The glass core 110 may be distinguished from, for example, the "prepreg" or "RF4" core of a PCB substrate which typically includes glass fibers embedded in a resinous organic material such as an epoxy. In such traditional cores/substrates including glass fibers and epoxy, the diameter of the glass fibers is generally in the range of 5 micron to 200 micron. In contract, the glass core 110 may be a layer of glass that is about 10 millimeters on a side to about 250 millimeters on a side (e.g., 10 millimeters x 10 millimeters to 250 millimeters x 250 millimeters). In some embodiments, a cross-section of the glass core 110 in an x-z plane, a y-z plane, and/or an x-y plane of an example coordinate system 105, shown in FIG. 1, may be substantially rectangular (axes shown in subsequent drawings refer to the axes of the coordinate system 105), although in some further embodiments the glass core 110 may have rounded or beveled edges/sides/sidewalls. In some embodiments, in the top-down view of the glass core 110 (e.g., the x-y plane of the coordinate system 105), the glass core 110 may have a first length in a range of 10 millimeters to 250 millimeters, and a second length in a range of 10 millimeters to 250 millimeters, the first length perpendicular to the second length. A thickness of the glass core 110 (e.g., a dimension measured along the z-axis of the coordinate system 105) may be in a range of about 50 micron to 1.4 millimeters. In some embodiments, the glass core 110 may be a glass core substrate, where the glass core substrate has a thickness in a range of about 50 microns to 1.4 millimeters. In some embodiments, the glass core 110 may be a layer of glass comprising a rectangular prism volume, possibly with rounded or beveled edges/sides/sidewalls. In some such embodiments, the rectangular prism volume may have a first side and a second side perpendicular to the first side, the first side having a length in a range of 10 millimeters to 250 millimeters and the second side having a length in a range of 10 millimeters to 250 millimeters. In some embodiments, the glass core 110 may be a rectangular prism volume with sections (e.g., vias) removed and filled with other materials (e.g., metal) e.g., the TGVs 115. In some embodiments, the glass core 110 may be a layer of glass having a thickness in a range of 50 microns to 1.4 millimeters, a first length in a range of 10 millimeters to 250 millimeters, and a second length in a range of 10 millimeters to 250 millimeters, the first length perpendicular to the second length.

In some implementations, together, the substrate 107, including the glass core 110, and the dies 114 may be referred to as a "a multi-layer die subassembly 104." The glass core 110 may provide mechanical stability to the multi-layer die subassembly 104, the substrate 107, and/or the microelectronic assembly 100. The glass core 110 may reduce warpage and may provide a more robust surface for attachment of the multi-layer die subassembly 104 to a package substrate 102 or other substrate (e.g., an interposer or a circuit board).

In some implementations, together, the dielectric material 112 of the substrate 107 and the glass core 110 may be referred to as a "multi-layer glass substrate." In some such embodiments, the multi-layer glass substrate may be a coreless substrate. In some such embodiments, the glass core 110 may be a glass layer having a thickness in a range of about 25 microns to 50 microns. In some embodiments, the further layers 111 may also be part of the multi-layer glass substrate.

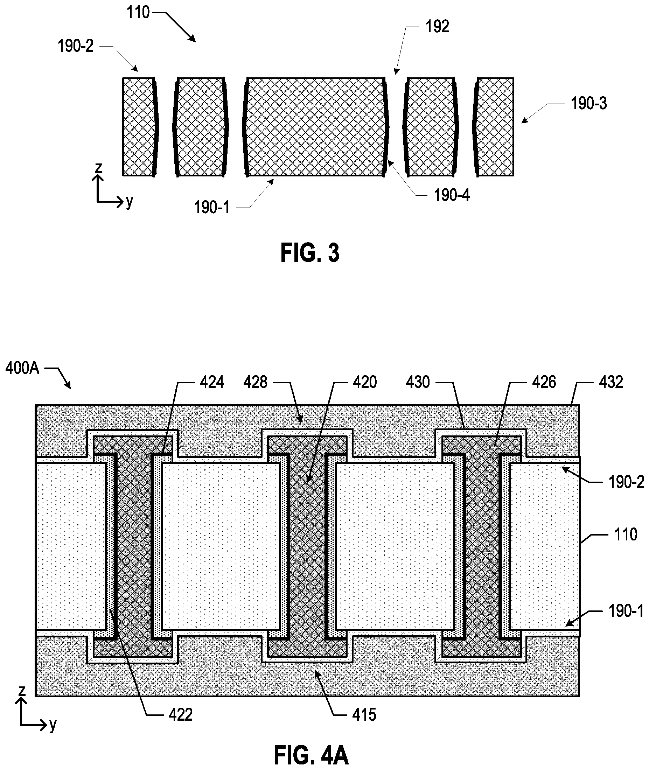

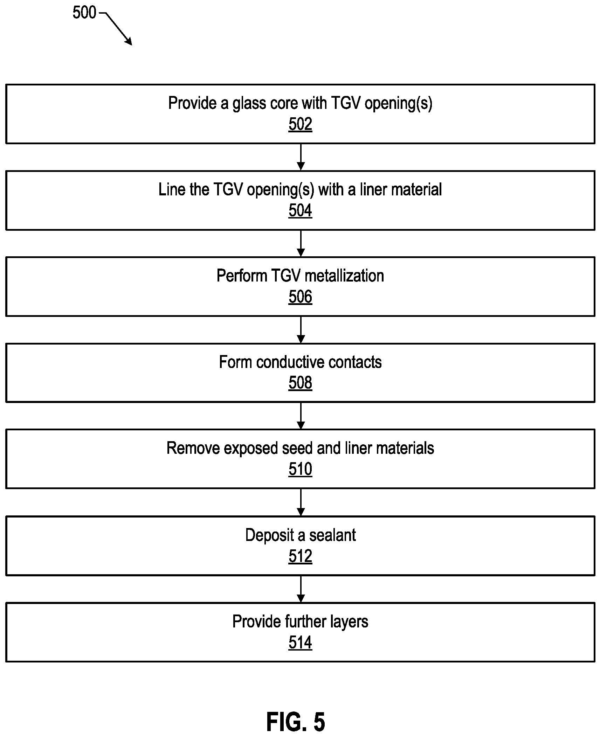

The TGVs 115 may be vias extending between a first side and a second side of the glass core 110 (e.g., between the bottom face and the top face of the glass core 110), the vias including any appropriate conductive material, e.g., a metal such as copper, silver, nickel, gold, aluminum, or other metals or alloys, for example. Openings for the TGVs 115 may be formed using any suitable process, including, for example, a direct laser drilling or laser-induced etching process (which may also be referred to as laser patterning or selective laser activation). For any of the TGVs 115, via metallization may be performed using any of the fabrication methods utilizing sealed liners as described herein, e.g., any of the methods shown in FIG. 5, FIG. 7, or FIG. 9. Therefore, although not specifically shown in FIG. 1 or FIG. 2, any of the TGVs 115 shown in these drawings may be implemented as described with respect to the fabrication methods shown in FIG. 5, FIG. 7, or FIG. 9 (e.g., as conductive vias with sealed liners as shown in any of FIGS. 4A-4C). In some embodiments, the TGVs 115 disclosed herein may have a pitch between 50 microns and 500 microns, e.g., as measured from a center of one TGV 115 to a center of an adjacent TGV 115. The TGVs 115 may have any suitable size and shape. In some embodiments, the TGVs 115 may have a circular, rectangular, or other shaped cross-section. In some embodiments, at least some of the TGVs 115 may have an hourglass shape, e.g., as shown in FIG. 2. In some embodiments, at least some of the TGVs 115 may taper down from one face of the glass core 110 to another, e.g., from the top face of the glass core 110 to the bottom face of the glass core 110.

The substrate 107 (e.g., further layers 111) may be coupled to a package substrate 102 by STPS interconnects 150. In particular, the top face of the package substrate 102 may include a set of conductive contacts 146. Conductive contacts 144 on the bottom face of the substrate 107 may be electrically and mechanically coupled to the conductive contacts 146 on the top face of the package substrate 102 by the STPS interconnects 150. The package substrate 102 may include an insulating material (e.g., a dielectric material formed in multiple layers, as known in the art) and one or more conductive pathways to route power, ground, and signals through the dielectric material (e.g., including conductive traces and/or conductive vias, as shown). In some embodiments, the insulating material of the package substrate 102 may be a dielectric material, such as an organic dielectric material, a fire retardant grade 4 material (FR-4), bismaleimide triazine (BT) resin, polyimide materials, glass reinforced epoxy matrix materials, organic dielectrics with inorganic fillers or low-k and ultra low-k dielectric (e.g., carbon-doped dielectrics, fluorine-doped dielectrics, porous dielectrics, and organic polymeric dielectrics). In particular, when the package substrate 102 is formed using standard PCB processes, the package substrate 102 may include FR-4, and the conductive pathways in the package substrate 102 may be formed by patterned sheets of copper separated by build-up layers of the FR-4. The conductive pathways in the package substrate 102 may be bordered by liner materials, such as adhesion liners and/or barrier liners, as suitable. In some embodiments, the package substrate 102 may be formed using a lithographically defined via packaging process. In some embodiments, the package substrate 102 may be manufactured using standard organic package manufacturing processes, and thus the package substrate 102 may take the form of an organic package. In some embodiments, the package substrate 102 may be a set of redistribution layers formed on a panel carrier by laminating or spinning on a dielectric material, and creating conductive vias and lines by laser drilling and plating. In some embodiments, the package substrate 102 may be formed on a removable carrier using any suitable technique, such as a redistribution layer technique. Any method known in the art for fabrication of the package substrate 102 may be used, and for the sake of brevity, such methods will not be discussed in further detail herein.

In some embodiments, the package substrate 102 may be a lower density medium and the die 114 may be a higher density medium or have an area with a higher density medium. As used herein, the term "lower density" and "higher density" are relative terms indicating that the conductive pathways (e.g., including conductive interconnects, conductive lines, and conductive vias) in a lower density medium are larger and/or have a greater pitch than the conductive pathways in a higher density medium. In some embodiments, a higher density medium may be manufactured using a modified semi-additive process or a semi-additive build-up process with advanced lithography (with small vertical interconnect features formed by advanced laser or lithography processes), while a lower density medium may be a PCB manufactured using a standard PCB process (e.g., a standard subtractive process using etch chemistry to remove areas of unwanted copper, and with coarse vertical interconnect features formed by a standard laser process). In other embodiments, the higher density medium may be manufactured using semiconductor fabrication process, such as a single damascene process or a dual-damascene process. In some embodiments, additional dies may be disposed on the top face of the dies 114-2, 114-3. In some embodiments, additional components may be disposed on the top face of the dies 114-2, 114-3. Additional passive components, such as surface-mount resistors, capacitors, and/or inductors, may be disposed on the top face or the bottom face of the package substrate 102, or embedded in the package substrate 102.

The microelectronic assembly 100 of FIG. 1 may also include an underfill material 127. In some embodiments, the underfill material 127 may extend between the substrate 107 and the package substrate 102 around the associated STPS interconnects 150. In some embodiments, the underfill material 127 may extend between different ones of the top level dies 114-2, 114-3 and the top face of the substrate 107 around the associated DTS interconnects 140 and between the bridge die 114-1 and the top level dies 114-2, 114-3 around the DTD interconnects 130. The underfill material 127 may be an insulating material, such as an appropriate epoxy material. In some embodiments, the underfill material 127 may include a capillary underfill, non-conductive film (NCF), or molded underfill. In some embodiments, the underfill material 127 may include an epoxy flux that assists with soldering the multi-layer die subassembly 104 to the package substrate 102 when forming the STPS interconnects 150, and then polymerizes and encapsulates the STPS interconnects 150. The underfill material 127 may be selected to have a CTE that may mitigate or minimize the stress between the substrate 107 and the package substrate 102 arising from uneven thermal expansion in the microelectronic assembly 100. In some embodiments, the CTE of the underfill material 127 may have a value that is intermediate to the CTE of the package substrate 102 (e.g., the CTE of the dielectric material of the package substrate 102) and a CTE of the dies 114 and/or dielectric material 112 of the substrate 107.

The STPS interconnects 150 disclosed herein may take any suitable form. In some embodiments, a set of STPS interconnects 150 may include solder (e.g., solder bumps or balls that are subject to a thermal reflow to form the STPS interconnects 150), for example, as shown in FIG. 1, the STPS interconnects 150 may include solder between a conductive contacts 144 on a bottom face of the substrate 107 and a conductive contact 146 on a top face of the package substrate 102. In some embodiments, a set of STPS interconnects 150 may include an anisotropic conductive material, such as an anisotropic conductive film or an anisotropic conductive paste. An anisotropic conductive material may include conductive materials dispersed in a non-conductive material.

The DTD interconnects 130 disclosed herein may take any suitable form. The DTD interconnects 130 may have a finer pitch than the STPS interconnects 150 in a microelectronic assembly. In some embodiments, the dies 114 on either side of a set of DTD interconnects 130 may be unpackaged dies, and/or the DTD interconnects 130 may include small conductive bumps (e.g., copper bumps). The DTD interconnects 130 may have too fine a pitch to couple to the package substrate 102 directly (e.g., too fine to serve as DTS interconnects 140 or STPS interconnects 150). In some embodiments, a set of DTD interconnects 130 may include solder. In some embodiments, a set of DTD interconnects 130 may include an anisotropic conductive material, such as any of the materials discussed above. In some embodiments, the DTD interconnects 130 may be used as data transfer lanes, while the STPS interconnects 150 may be used for power and ground lines, among others. In some embodiments, some or all of the DTD interconnects 130 in a microelectronic assembly 100 may be metal-to-metal interconnects (e.g., copper-to-copper interconnects, or plated interconnects). In such embodiments, the DTD interconnect 130 may be bonded together (e.g., under elevated pressure and/or temperature) without the use of intervening solder or an anisotropic conductive material. Any of the conductive contacts disclosed herein (e.g., the conductive contacts 122, 124, 144, and/or 146) may include bond pads, solder bumps, conductive posts, or any other suitable conductive contact, for example. In some embodiments, some or all of the DTD interconnects 130 and/or the DTS interconnects 140 in a microelectronic assembly 100 may be solder interconnects that include a solder with a higher melting point than a solder included in some or all of the STPS interconnects 150. For example, when the DTD interconnects 130 and the DTS interconnects 140 in a microelectronic assembly 100 are formed before the STPS interconnects 150 are formed, solder-based DTD interconnects 130 and DTS interconnects 140 may use a higher-temperature solder (e.g., with a melting point above 200 degrees Celsius), while the STPS interconnects 150 may use a lower-temperature solder (e.g., with a melting point below 200 degrees Celsius). In some embodiments, a higher-temperature solder may include tin; tin and gold; or tin, silver, and copper (e.g., 96.5 % tin, 3% silver, and 0.5% copper). In some embodiments, a lower-temperature solder may include tin and bismuth (e.g., eutectic tin bismuth) or tin, silver, and bismuth. In some embodiments, a lower-temperature solder may include indium, indium and tin, or gallium.

In the microelectronic assemblies 100 disclosed herein, some or all of the DTS interconnects 140 and the STPS interconnects 150 may have a larger pitch than some or all of the DTD interconnects 130. DTD interconnects 130 may have a smaller pitch than STPS interconnects 150 due to the greater similarity of materials in the different dies 114 on either side of a set of DTD interconnects 130 than between the substrate 107 and the top level dies 114-2, 114-3 on either side of a set of DTS interconnects 140, and between the substrate 107 and the package substrate 102 on either side of a set of STPS interconnects 150. In particular, the differences in the material composition of a substrate 107 and a die 114 or a package substrate 102 may result in differential expansion and contraction due to heat generated during operation (as well as the heat applied during various manufacturing operations). To mitigate damage caused by this differential expansion and contraction (e.g., cracking, solder bridging, etc.), the DTS interconnects 140 and the STPS interconnects 150 may be formed larger and farther apart than DTD interconnects 130, which may experience less thermal stress due to the greater material similarity of the pair of dies 114 on either side of the DTD interconnects. In some embodiments, the DTS interconnects 140 disclosed herein may have a pitch between 25 microns and 250 microns. In some embodiments, the STPS interconnects 150 disclosed herein may have a pitch between 55 microns and 1000 microns, while the DTD interconnects 130 disclosed herein may have a pitch between 25 microns and 100 microns.

The microelectronic assembly 100 of FIG. 1 may also include a circuit board (not shown). The package substrate 102 may be coupled to the circuit board by second-level interconnects at the bottom face of the package substrate 102. The second-level interconnects may be any suitable second-level interconnects, including solder balls for a ball grid array arrangement, pins in a pin grid array arrangement or lands in a land grid array arrangement. The circuit board may be a motherboard, for example, and may have other components attached to it. The circuit board may include conductive pathways and other conductive contacts for routing power, ground, and signals through the circuit board, as known in the art. In some embodiments, the second-level interconnects may not couple the package substrate 102 to a circuit board, but may instead couple the package substrate 102 to another IC package, an interposer, or any other suitable component. In some embodiments, the substrate 107 may not be coupled to a package substrate 102, but may instead be coupled to a circuit board, such as a PCB.

Although FIG. 1 depicts a microelectronic assembly 100 having a substrate with a particular number of dies 114 and conductive pathways provided by the conductive material 108 coupled to other dies 114, this number and arrangement are simply illustrative, and a microelectronic assembly 100 may include any desired number and arrangement of dies 114. Although FIG. 1 shows the die 114-1 as a double-sided die and the dies 114-2, 114-3 as single-sided dies, the dies 114-2, 114-3 may be double-sided dies and the dies 114 may be a single-pitch die or a mixed-pitch die. In some embodiments, additional components may be disposed on the top face of the dies 114-2 and/or 114-3. In this context, a double-sided die refers to a die that has connections on both surfaces. In some embodiments, a double-sided die may include through TSVs to form connections on both surfaces. The active surface of a double-sided die, which is the surface containing one or more active devices and a majority of interconnects, may face either direction depending on the design and electrical requirements.

Many of the elements of the microelectronic assembly 100 of FIG. 1 are included in other ones of the accompanying drawings; the discussion of these elements is not repeated when discussing these drawings, and any of these elements may take any of the forms disclosed herein. Further, various elements are illustrated in FIG. 1 as included in the microelectronic assembly 100, but, in various embodiments, some of these elements may not be included. For example, in various embodiments, the further layers 111, the underfill material 127, and the package substrate 102 may not be present in the microelectronic assembly 100. In some embodiments, individual ones of the microelectronic assemblies 100 disclosed herein may serve as a system-in-package (SiP) in which multiple dies 114 having different functionality are included. In such embodiments, the microelectronic assembly 100 may be referred to as an SiP.

FIG. 2 is a schematic cross-sectional view of another example microelectronic assembly 100 according to some embodiments of the present disclosure. The configuration of the embodiment shown in the figure is like that of FIG. 1, except for differences as described further. Instead of including the glass core 110 as a part of the substrate 107, as was shown in FIG. 1, the microelectronic assembly 100 of FIG. 2 includes a glass core 110 on its own, where one or more dies 114 may be coupled to the glass core 110. In FIG. 2, the multi-layer die subassembly 104 includes the glass core 110 and the plurality of dies 114 as described above. The multi-layer die subassembly 104 may have a first surface 160-1 (e.g., the bottom face) and an opposing second surface 160-2 (e.g., the top face). The glass core 110 may provide mechanical stability to the multi-layer die subassembly 104 and/or the microelectronic assembly 100 of FIG. 2, may reduce warpage, and may provide a more robust surface for attachment of the multi-layer die subassembly 104 to a package substrate 102 or other substrate (e.g., an interposer or a circuit board).

The glass core 110 may include a cavity 129 with an opening facing the second surface 160-2 and the die 114-1 may be nested, fully or at least partially, in the cavity 129. As shown in FIG. 2, in cases where the die 114-1 is fully nested in a cavity 129, a top face of the die 114-1 may be planar with or below a top face of the glass core 110. In cases where the die 114-1 is partially nested in a cavity 129, a top face of the die 114-1 may extend above a top face of the glass core 110. The cavity 129 may be at least partially filled with a dielectric material 112A or 112B, described above. The die 114-1 may be attached to a bottom face of the cavity 129 by a die-attach film (DAF) 132. A DAF 132 may be any suitable material, including a non-conductive adhesive, die-attach film, a B-stage underfill, or a polymer film with adhesive property. A DAF 132 may have any suitable dimensions, for example, in some embodiments, a DAF 132 may have a thickness (e.g., height or z-height) between 5 microns and 10 microns.

The die 114-1 may be coupled to the dies 114-2, 114-3 in a layer above the die 114-1 through the DTD interconnects 130. The DTD interconnects 130 may be disposed between some of the conductive contacts 122 at the bottom of the dies 114-2, 114-3 and some of the conductive contacts 124 at the top of the die 114-1. Some other conductive contacts 122 at the bottom of the dies 114-2 and/or 114-3 may further couple one or more of the dies 114-2, 114-3 to the glass core 110 by glass core-to-die (GCTD) interconnects 142. The GCTD interconnects 142 may be disposed between some of the conductive contacts 122 at the bottom of the dies 114-2, 114-3 and some of the conductive contacts 128 at the top of the glass core 110. The GCTD interconnects 142 may be similar to the DTS interconnects 140, described above. In some embodiments, the underfill material 127 may extend between different ones of the dies 114 around the associated DTD interconnects 130 and/or GCTD interconnects 142. In some embodiments, a die 114-2 and/or a die 114-3 may be embedded in an insulating material 133. In some embodiments, an overall thickness (e.g., a z-height) of the insulating material 133 may be between 200 microns and 800 microns (e.g., substantially equal to a thickness of die 114-2 or 114-3 and the underfill material 127). In some embodiments, the insulating material 133 may form multiple layers (e.g., a dielectric material formed in multiple layers, as known in the art) and may embed one or more dies 114 in a layer. In some embodiments, the insulating material 133 may be a dielectric material, such as an organic dielectric material, a fire retardant grade 4 material (FR-4), BT resin, polyimide materials, glass reinforced epoxy matrix materials, or low-k and ultra low-k dielectric (e.g., carbon-doped dielectrics, fluorine-doped dielectrics, porous dielectrics, and organic polymeric dielectrics). In some embodiments, the insulating material 133 may be a mold material, such as an organic polymer with inorganic silica particles.

As shown in FIG. 2, the glass core 110 may further include conductive contacts 126 at the bottom of the glass core 110, and TGVs 115 may extend between and electrically couple conductive contacts 126 at the bottom of the glass core 110 and conductive contacts 128 at the top of the glass core 110. The conductive contacts 126, 128 may be similar to other conductive contacts disclosed herein (e.g., the conductive contacts 122, 124, 144, and/or 146), and may include bond pads, solder bumps, conductive posts, or any other suitable conductive contact, for example. As shown in FIG. 2, in some embodiments, at least some of the TGVs 115 may have an hourglass shape. For example, at least some of the TGVs 115 may has a first width at the first face of the glass core 110 (e.g., at the bottom face of the glass core 110), a second width at the second face of the glass core 110 (e.g., at the top face of the glass core 110), and a third width between the first face and the second face of the glass core 110, where the third width is smaller than the first width and the second width.

The dies 114-2, 114-3 may be electrically coupled to the package substrate 102 through the TGVs 115 and glass core-to-package substrate (GCTPS) interconnects 152, which may be power delivery interconnects or high-speed signal interconnects. The GCTPS interconnects 152 may be similar to the STPS interconnects 150, described above. The top face of the package substrate 102 may include a set of conductive contacts 146, the multi-layer die subassembly 104 may include a set of conductive contacts 126 on the first surface 160-1, and the GCTPS interconnects 152 may be between, and couple the conductive contacts 146 with corresponding ones of the conductive contacts 126. In some embodiments, the underfill material 127 may extend between the glass core 110 and the package substrate 102 around the associated GCTPS interconnects 152.

The glass core 110 included in a microelectronic assembly 100 as described with reference to FIG. 1 or FIG. 2 or included in any other microelectronic assembly or device, may be subject to TGV stress prior to inclusion in the microelectronic assembly 100. For example, FIG. 3 illustrates surfaces of a glass core 110 from which TGV stress may initiate, according to some embodiments of the present disclosure. As shown in FIG. 3, a glass core 110 may have a first face 190-1 and an opposing second face 190-2, e.g., be bottom and top faces when the glass core 110 is included in a microelectronic assembly 100 (where, together, the first and second faces 190-1, 190-2 may be referred to as "faces 190"). The glass core 110 may also include a side 190-3, which is a surface of the glass core 110 that may be referred to as an edge or a sidewall of the glass core 110, i.e., a surface that extends between the first face 190-1 and the second face 190-2. As further shown in FIG. 3, TGV openings 192 may be formed in the glass core 110, extending between the first face 190-1 and the second face 190-2. A sidewall 190-4 may then refer to one or more sidewalls of the TGV openings 192. When a conductive material is deposited in the TGV openings 192, TGV stress may initiate from the sidewall 190-4 due to CTE mismatch between the glass material of the glass core 110 and the conductive material in the TGV openings 192.

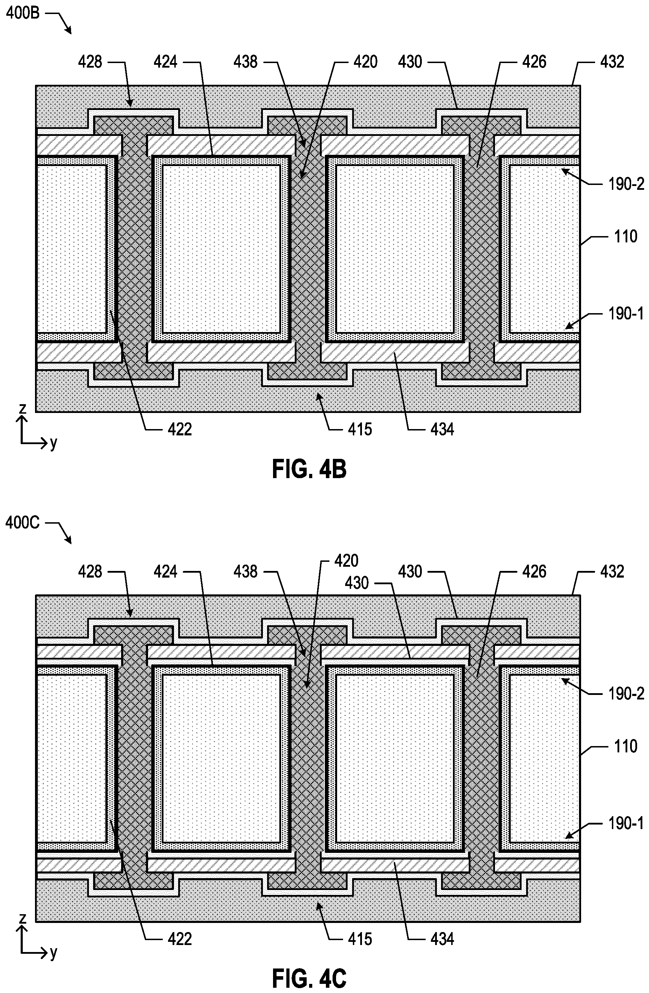

One or more techniques for TGV stress alleviation as described herein may be applied to reduce TGV stress at the sidewalls 190-4, before including the glass core 110 in a microelectronic assembly 100. In particular, various techniques for TGV stress alleviation are based on implementing conductive vias (e.g., TGVs 115) in glass cores as conductive vias with sealed liners. To that end, three different fabrication methods for providing conductive vias with sealed liners are described herein, as shown in FIGS. 5, 7, and 9. As a result of carrying out the methods of FIGS. 5, 7, and 9, microelectronic assemblies 400A, 400B, and 400C with different arrangements of sealed liners may be realized, as shown in FIGS. 4A, 4B,and 4C, respectively. Each of the microelectronic assemblies 400A-400C may be an example of a portion of any of the microelectronic assemblies 100 described herein. FIG. 4A, FIG. 4B, and FIG. 4C illustrate cross-sectional side views (e.g., views of a y-z plane of the example coordinate system 105, described herein) of a portion of a glass core 110 in which three conductive vias with sealed liners are fabricated using metallization processes of the methods 500, 700, and 900, respectively.

Each of FIGS. 4A-4C illustrates a glass core 110 with three TGVs 415 extending between the first and second faces 190-1, 190-2, where an individual TGV 415 includes a TGV opening 420, a liner material 422 on sidewall(s) of the TGV opening 420, a seed material 424 over the liner material 422, and a conductive fill material 426 filling the remaining space of the TGV opening 420, with conductive contacts 428 provided at the opposite ends of the TGV 415. Each of FIGS. 4A-4C further illustrates a sealant 430, configured to seal the liner material 422 in the TGVs 415, e.g., the glass core 110, the conductive materials in the TGV openings (e.g., the seed material 424 and the conductive fill material 426), and the sealant 430 may completely enclose the liner material 422 as to reduce or eliminate oxidation of the liner material 422. Thus, because of the presence of the sealant 430 as described herein, the liner material 422 may be referred to as a "sealed liner" of the TGVs 415. FIGS. 4A-4C further illustrate further layers 432 on the opposite faces 190 of the glass core 110.

Although the TGVs 415 are shown in the present drawings as extending all the way through the thickness of the glass cores 110, in other embodiments, any of the TGVs 415 may be a blind via, in which case the sealant 430 would only be provided over one face 190 of the glass core 110, the face from which the blind via starts. Furthermore, although further layers 432 are shown in FIGS. 4A-4C on both faces 190-1 and 190-2 of the glass cores 110, in some embodiments, further layers 432 may be absent on the first face 190-1, the second face 190-2, or both faces 190-1 and 190-2. Still further, although three TGVs 415 are shown in the present drawings, in other embodiments, the microelectronic assemblies 400-400C may include any number of one or more TGVs 415.

FIGS. 4A-4C differ in how the sealant 430 is implemented with respect to the glass core 110. In particular, in the microelectronic assembly 400A shown in FIG. 4A, the sealant 430 may be in contact with one or more portions of the first face 190-1 and/or one or more portions of the second face 190-2 of the glass core 110. As used herein, unless specified otherwise, description of element A being "in contact" with element B includes element A being in direct physical contact with element B. In contrast to FIG. 4A, in the microelectronic assembly 400B shown in FIG. 4B, the sealant 430 is not in contact with any portions of the first face 190-1 or the second face 190-2 of the glass core 110 because a buffer layer 434 is provided over these faces so that, e.g., for the first face 190-1, the buffer layer 434 is between the first face 190-1 and the sealant 430, e.g., between the liner material 422 over the first face 190-1 and the sealant 430. In the microelectronic assembly 400C shown in FIG. 4C, two of layers of the sealant 430 may be provided, with one layer being as shown in FIG. 4B, and another layer of the sealant 430 being between the buffer layer 434 and the first face 190-1, e.g., between the buffer layer 434 and the liner material 422 over the first face 190-1.

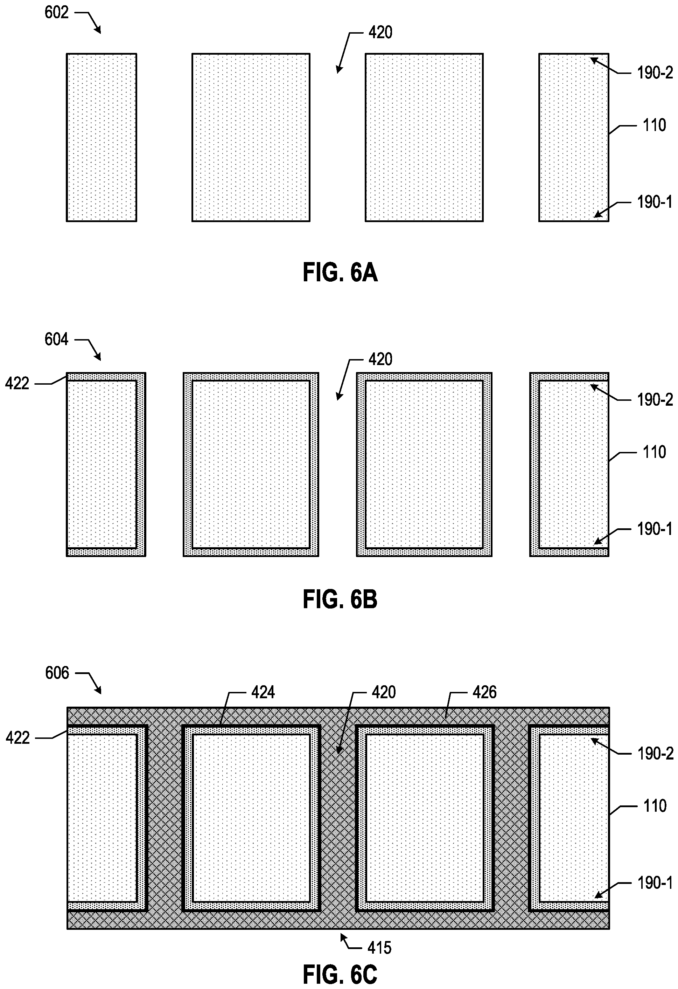

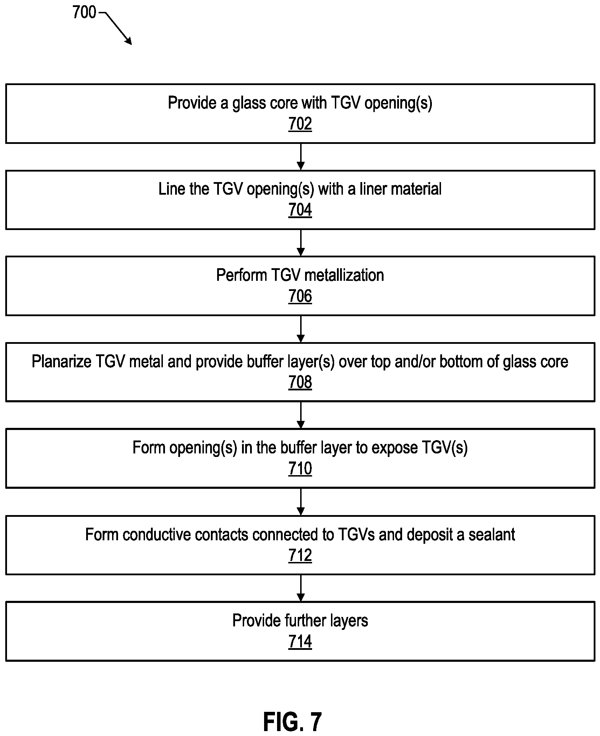

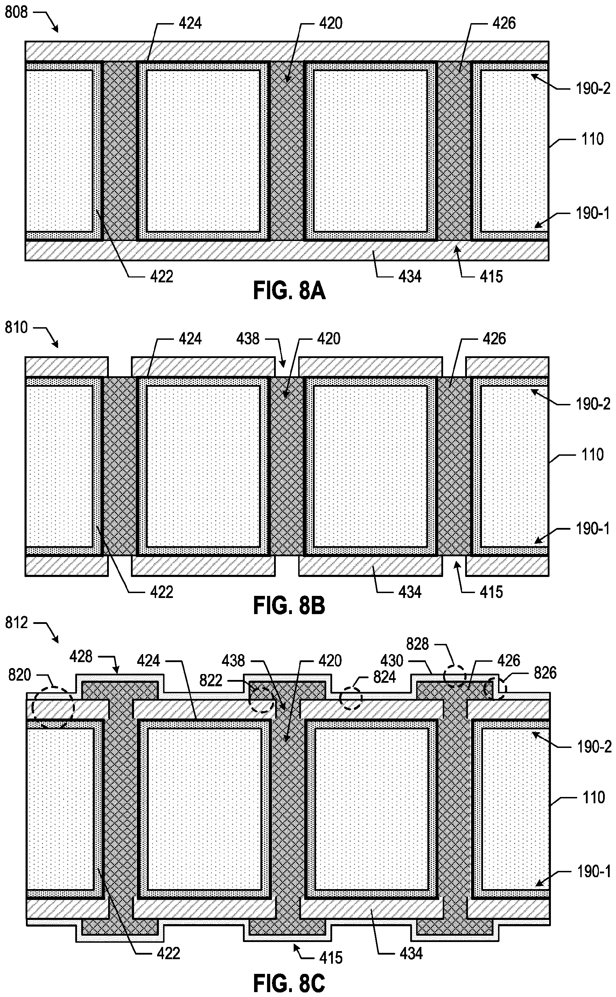

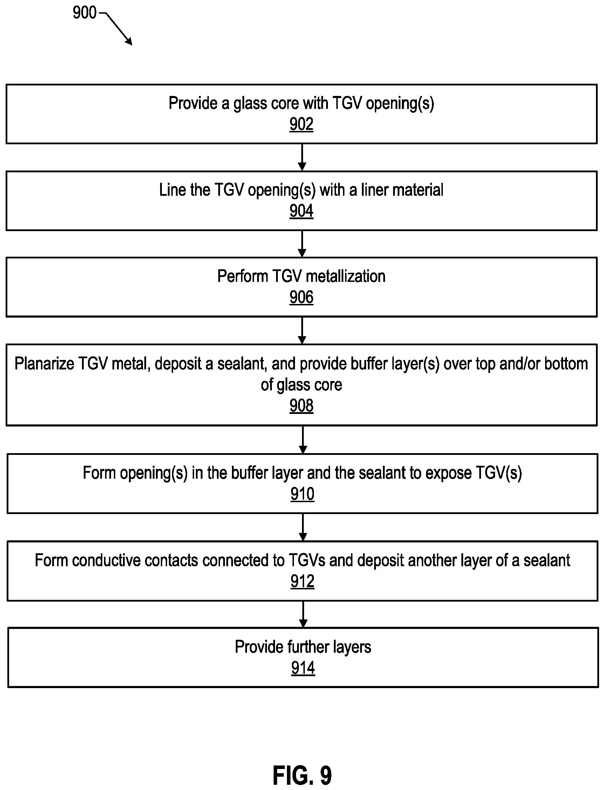

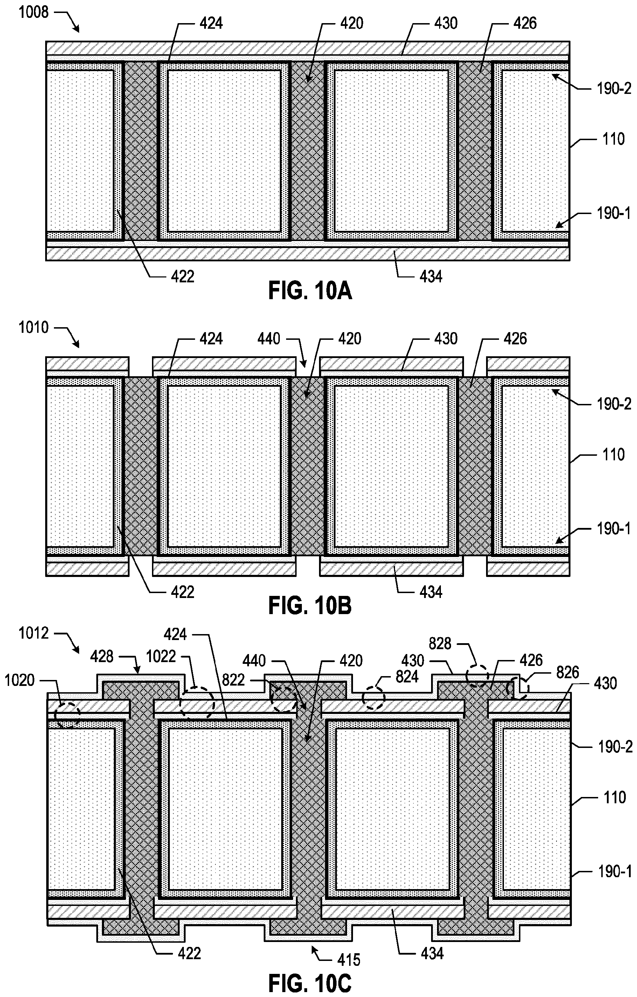

Turning to the details of how the TGVs 415 with sealed liners of FIGS. 4A-4C may be fabricated, FIG. 5, FIG. 7, and FIG. 9 are flow diagrams of, respectively, a method 500, a method 700, and a method 900 of providing a glass core with a sealed liner, in accordance with various embodiments. FIGS. 6A-6F provide cross-sectional side views at various stages in the fabrication of an example glass core with a sealed liner according to the method 500 of FIG. 5, in accordance with some embodiments. FIGS. 8A-8C provide cross-sectional side views at various stages in the fabrication of an example glass core with a sealed liner according to the method 700 of FIG. 7, in accordance with some embodiments. FIGS. 10A-10C provide cross-sectional side views at various stages in the fabrication of an example glass core with a sealed liner according to the method 900 of FIG. 9, in accordance with some embodiments. Similar to FIGS. 4A-4C, each of FIGS. 6A-6F, FIGS. 8A-8C, and FIGS. 10A-10C illustrates a cross-sectional side view (e.g., a view of a y-z plane of the example coordinate system 105, described herein) of a portion of a glass core 110 in which three conductive vias with sealed liners are fabricated using metallization processes of the methods 500, 700, and 900.

Although the operations of the methods 500, 700, and 900 are illustrated once each and in a particular order, the operations may be performed in any suitable order and repeated as desired. For example, one or more operations may be performed in parallel to fabricate multiple conductive vias with sealed liners substantially simultaneously. In another example, one or more operations may be performed in parallel to fabricate conductive vias with sealed liners in multiple glass cores substantially simultaneously.

In addition, the example fabricating methods 500, 700, and 900 may include other operations not specifically shown in FIGS. 5, 7, and 9, such as various cleaning or planarization operations as known in the art. For example, in some embodiments, a glass core 110, as well as layers of various other materials subsequently deposited thereon, may be cleaned prior to, after, or during any of the processes of the methods 500, 700, and 900 described herein, e.g., to remove oxides, surface-bound organic and metallic contaminants, as well as subsurface contamination. In some embodiments, cleaning may be carried out using e.g., a chemical solutions (such as peroxide), and/or with ultraviolet (UV) radiation combined with ozone, and/or oxidizing the surface (e.g., using thermal oxidation) then removing the oxide (e.g., using hydrofluoric acid (HF)).

The method 500 may begin with a process 502 that includes providing a glass core with one or more TGV openings therein. FIG. 6A illustrates an assembly 602 that may be an example result of the process 502, showing a glass core 110 with TGV openings 420 therein. Again, FIG. 6A as well as FIGS. 6B-6F, FIGS. 8A-8C, and FIGS. 10A-10C illustrate TGV openings 420 in the glass core 110 to be extending between the first face 190-1 and the second face 190-2 of the glass core 110, although descriptions provided herein are applicable to openings that are blind openings, e.g., openings that start at one of the faces 190 and extend towards, but do not reach, the other one of the faces 190. In some embodiments, the TGV openings 420 may be formed in the glass core 110 using any suitable subtractive technique such as direct laser drilling or laser-induced etching process, possibly in combination with any suitable patterning technique such as photolithographic or electron-beam (e-beam) patterning. In other embodiments, the TGV openings 420 may be formed during fabrication of the glass core 110 itself, e.g., when molten glass is filled into a mold that has space for the future TGV openings 420.

Next, the method 500 may include a process 504, in which the TGV openings 420 of the process 502 may be lined with a liner material. To that end, a layer of a liner material may be deposited on sidewalls of the TGV openings 420 of the process 502 and, possibly, also on the bottoms of the TGV openings 420 for those TGV openings 420 that may be implemented as blind openings. FIG. 6B illustrates an assembly 604 that may be an example result of the process 504, showing a glass core 110 in which the TGV openings 420 are lined with a layer of a liner material 422, thus creating lined TGV openings. In various embodiments, the liner material 422 may be deposited using any suitable deposition technique such as chemical vapor deposition (CVD), atomic layer deposition (ALD), or physical vapor deposition (PVD). In some embodiments, besides being deposed as a liner in the TGV openings 420, the liner material 422 may also be deposited over the first face 190-1, the second face 190-2, or both faces 190, depending on how the liner material 422 is deposited. In such embodiments, the liner material 422 deposited over the first face 190-1 and/or the second face 190-2 may be materially continuous with the liner material 422 on the sidewalls of the TGV openings 420. In some embodiments, portions of the liner material 422 on the sidewalls of the TGV openings 420 may be in contact with the sidewalls of the TGV openings 420 (e.g., in contact with the glass core 110 at the sidewalls of the TGV openings 420). In some embodiments, a thickness of the liner material 422 may be between about 200 nanometers and about 10 microns, e.g., between about 200 nanometers and about 5 microns, or between about 500 nanometers and about 1 micron. In some embodiments, the liner material 422 may be deposited as a conformal layer, i.e., it may be conformal to the shapes of the underlying surfaces over which the liner material 422 is deposited.

The liner material 422 may include any suitable material that may separate the glass materials of the glass core 110 at the sidewalls of the TGV openings 420 and the conductive materials that will later be deposited in the TGV openings 420. In some embodiments, the liner material 422 may include a material having a relatively low modulus, e.g., having Young's modulus below about 30 GPa, e.g., below about 10 GPA, e.g., between about 3 GPa and 30 GPa or between about 1 GPa and 30 GPa, where the Young's modulus may be defined as the ratio of stress to strain in a material undergoing deformation. In some embodiments, the liner material 422 may include a material having a modulus (e.g., Young's modulus) smaller than that of the glass core 110 and/or having a modulus (e.g., Young's modulus) smaller than that of the conductive fill material 426 deposited in a later process. In some embodiments, a CTE of the liner material 422 may be smaller than a CTE of the conductive fill material 426, e.g., smaller than about 17 ppm/K or smaller than about 15 ppm/K or 10 ppm/K.

In some embodiments, the liner material 422 may include a polymer material, e.g., an organic polymer. In other embodiments, the liner material 422 may include an organic material other than a polymer, e.g., monomers or oligomers. In some embodiments, the liner material 422 may include a homopolymer, which is a polymer composed of repeating units of a single type of monomer. Simple signal chemical system organic liners such as homopolymers may be particularly advantageous for use as the liner material 422 because they may be relatively easy to manufacture and because they can be adapted readily for use as the liner material 422. In some embodiments, the liner material 422 may include poly-para-xylylene (which is also commonly referred to as "parylene"), such as parylene N, parylene C, parylene D, or parafree (halogen free). In other embodiments, the liner material 422 may include a heteropolymer, which is a polymer composed of repeating units of two or more types of monomers or oligomers. For example, the liner material 422 may include heteropolymers such as polyester (PET), polyurethane (PU), polycarbonate (PC), or polyvinyl chloride (PVC).

In other embodiments, the liner material 422 may include a material that is not a polymer, e.g., an inorganic non-polymer material. In some such embodiments, the liner material 422 may include inorganic materials such as carbon-doped oxide (CDO), low modulus SiOx, silicon oxycarbide (SiOC), or other low-k dielectrics.

The method 500 may then proceed with a process 506, in which TGV metallization may be performed on the assembly 604 with the TGV openings 420 lined with the liner material 422. FIG. 6C illustrates an assembly 606 that may be an example result of the process 506, showing that TGV metallization may include depositing a layer of a seed material 424 to line the TGV openings 420 lined with the liner material 422, and then at least partially fill the remaining space in the TGV openings 420 with a conductive fill material 426, thus creating conductive vias in the form of TGVs 415. The TGVs 415 are one example of any of the TGVs 115, described herein. The seed material 424 may include any suitable conductive material, e.g., a metal, a metal alloy, or a combination of metals, e.g., a low-resistivity metal such as copper, that can be deposited in a thin layer on substantially non-conductive surfaces (e.g., sidewalls) of the TGV openings 420 lined with the liner material 422. The seed material 424 provides a conductive surface for uniform and controlled deposition of a conductive fill material in a subsequent step of the TGV metallization of the process 506. For example, the seed material 424 may serve as a foundation or base for the subsequent electroplating of a thicker layer of metal. In some embodiments, the seed material 424 may include one or more metals such as copper, ruthenium, nickel, gold, palladium, platinum, or silver. In various embodiments, a thickness of the layer of the seed material 424, e.g., as measured in a direction perpendicular to the sidewalls of the TGV openings 420, may be between about 5 nanometer and 20 micron, e.g., between about 10 nanometers and 15 micron, or between about 10 nanometers and 1 micron. In various embodiments, the seed material 424 may be deposited using any suitable deposition technique such as CVD, ALD, or PVD. In some embodiments, the seed material 424 may be deposited as a conformal layer. In some embodiments, the seed material 424 may include two or more layers of different conductive materials, deposited on the liner material 422 sequentially. For example, the seed material 424 may include a layer of a first material deposited on the liner material 422, and then a layer of a second material deposited on the first material. The first material may be a conductive material that has good adhesive properties in terms of adhesion between the first material and the liner material 422, and, possibly, in terms of adhesion between the first material and the second material. The second material may be a conductive material that may protect the first material from oxidation before and/or during deposition of the conductive filler material in a subsequent process. For example, the first layer of the seed material 424 may include titanium, while the second layer of the seed material 424 may include copper. In other embodiments, the seed material 424 may include a single layer of a conductive material, e.g., a layer of copper or a layer of ruthenium. The conductive fill material 426 may include any suitable conductive material, e.g., any of the materials described with reference to the seed material 424. In some embodiments, material compositions of the seed material 424 and the conductive fill material 426 may be substantially the same, e.g., both may be, or may include, copper. In other embodiments, material compositions of the seed material 424 and the conductive fill material 426 may be different. The conductive fill material 426 may be deposited using any suitable deposition technique such as electroplating, ALD, CVD, or PVD.

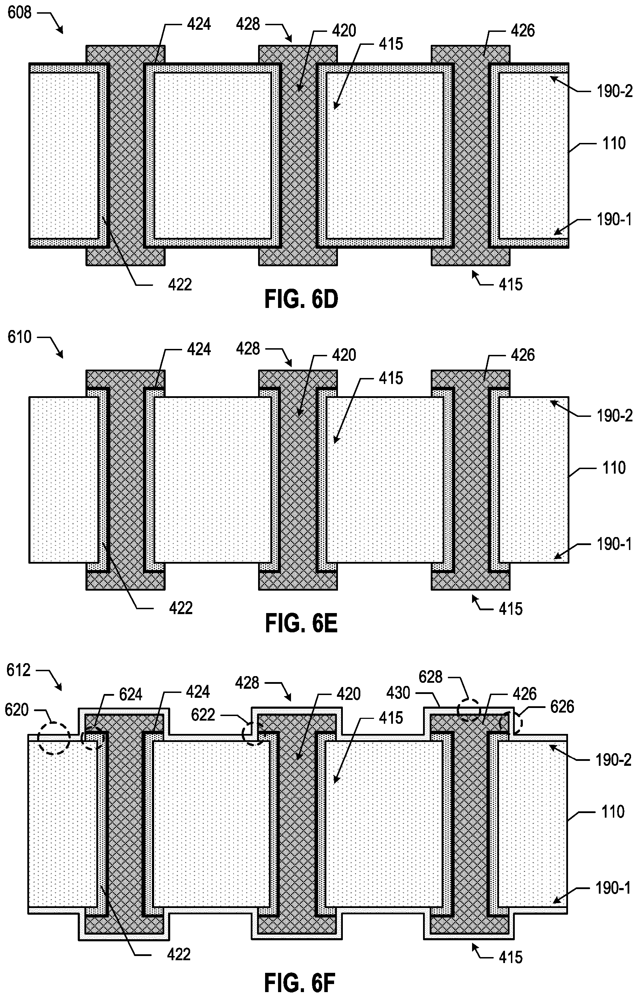

Next, the method 500 may include a process 508, in which conductive contacts are formed at the ends of the TGV openings 420 of the assembly 606. FIG. 6D illustrates an assembly 608 that may be an example result of the process 508, showing a glass core 110 with conductive contacts 428 at the opposite ends of the TGV openings 420. In some embodiments, the conductive contacts 428 may be fabricated by removing remainder of the overburden of the conductive fill material 426 that may be deposited over the faces 190 in the process 506, e.g., using any suitable etching process, possibly in combination with any suitable patterning technique such as photolithographic or e-beam patterning.

The method 500 may further include a process 510, in which the seed material 424 and the liner material 422 exposed by the removal of the conductive fill material 426 to form the conductive contacts 428 in the process 508 may be removed as well. FIG. 6E illustrates an assembly 610 that may be an example result of the process 510, showing that the seed material 424 and the liner material 422 on portions of the faces 190 that are outside the footprint of the conductive contacts 428 may be removed, exposing the surfaces of the glass core 110. In some embodiments, the process 510 may include any suitable etching process, e.g., a two-step etching process in which a first set of one or more etchants is used to remove the seed material 424, thus exposing the liner material 422, and then a second set of one or more etchants is used to remove the liner material 422. In other embodiments, the conductive contacts 428 may be provided using any other suitable techniques, e.g., using additive techniques to add the conductive contacts 428, as long as the conductive fill material 426 of the TGVs 415 may be brought in conductive contact with conductive materials of the conductive contacts 428. Descriptions provided with respect to conductive contacts of the microelectronic assemblies 100 shown in FIGS. 1-2 (e.g., the conductive contacts 122) are applicable to the conductive contacts 428 and, therefore, for the sake of brevity, are not repeated.

Next, the method 500 may include a process 512, in which a sealant is deposited to seal the liner material 422. FIG. 6F illustrates an assembly 612 that may be an example result of the process 512, showing a layer of a sealant 430 deposited over the top and bottom surfaces of the assembly 610, enclosing the liner material 422 in the TGVs 415. The sealant 430 may be deposited using any suitable deposition technique such as electroplating, ALD, CVD, or PVD. In some embodiments, a thickness of the sealant 430 may be between about 100 nanometers and about 10 microns, e.g., between about 200 nanometers and about 5 microns, or between about 250 nanometers and about 1 microns. In some embodiments, the sealant 430 may be deposited as a conformal layer.

In some embodiments, the sealant 430 may include any suitable material that may reduce or eliminate oxidation of the liner material 422. For example, in some such embodiments, the sealant 430 may include an inorganic material, e.g., silicon nitride. In other such embodiments, the sealant 430 may include other nitrides, or other materials that do not oxidize easily and that may withstand subsequent processes that may be applied to the assembly 612. In other embodiments, the sealant 430 may include any suitable material that may reduce or eliminate crystallization of the liner material 422. For example, in some such embodiments, the sealant 430 may include an inorganic material, e.g., silicon oxide. In other such embodiments, the sealant 430 may include other oxides, or other materials that may reduce or eliminate crystallization of the liner material 422 and that may withstand subsequent processes that may be applied to the assembly 612. The choice of the material(s) used as the sealant 430 may depend on the specific application, environmental conditions, and the choice of the liner material 422 being sealed. In various embodiments, the sealant 430 may include one or more of silicone, polyurethane, an acrylic material, fluorosilicone, butyl rubber, epoxy, neoprene, or polyvinyl chloride.

The method 500 may further include a process 514 in which further layers are provided over the first face 190-1 and/or over the second face 190-2 of the glass core 110 of the assembly 612. FIG. 4A, described above, illustrates an example result of the process 514, showing further layers 432 provided over the first face 190-1 and over the second face 190-2 of the glass core 110. In some embodiments, the further layers 432 may include build-up layers, e.g., build-up layers described with reference to FIGS. 1-2. In some embodiments, the further layers 432 may include ABF. In some embodiments, the sealant 430 may be a material that can promote adhesion of the further layers 432 to the top and/or bottom surfaces of the assembly 612.

Performing the method 500 may result in several features characteristic of the use of the method 500. One such feature may be that, in some embodiments, a portion of the sealant 430 may be in contact with a portion of the first face 190-1 of the glass core 110 and/or a portion of the sealant 430 may be in contact with a portion of the second face 190-2 of the glass core 110, e.g., portions of the sealant 430 that are not on the conductive contacts 428. An example of that may be seen within a dashed contour 620, shown in FIG. 6F. Another feature characteristic of the use of the method 500 may be that a portion of the liner material 422 over a given face 190 of the glass core 110 may be in contact with a portion of the sealant 430. An example of that may be seen within a dashed contour 622, shown in FIG. 6F. Similarly, a portion of the seed material 424 over a given face 190 of the glass core 110 may be in contact with a portion of the sealant 430, as can also be seen within the dashed contour 622 of FIG. 6F. Yet another feature characteristic of the use of the method 500 may be that a portion of the liner material over a given face 190 of the glass core 110 may be in contact with a portion of that face 190 of the glass core 110. An example of that may be seen within a dashed contour 624, shown in FIG. 6F. Because in the method 500 the sealant 430 is deposited after formation of the conductive contacts 428, in some embodiments, a portion of the sealant 430 may be on a sidewall of a conductive contact 428, e.g., as shown within a dashed contour 626, shown in FIG. 6F, while another portion of the sealant 430 may be on the top surface of a conductive contact 428, e.g., as shown within a dashed contour 628, shown in FIG. 6F.

Turning to the second method of providing a glass core with sealed liners, the method 700, shown in FIG. 7, may include processes 702, 704, and 706, which may be substantially the same as the processes 502, 504, and 506, respectively, described with reference to the method 500. For the sake of brevity, descriptions of these processes are not repeated and their illustrations at not shown in FIGS. 8A-8C. After the process 706, the method 700 may include a process 708, in which TGV metals deposited over the faces 190 during the TGV metallization of the process 706 may be planarized and a buffer layer may be provided over the first face 190-1 and/or the second face 190-2. FIG. 8A illustrates an assembly 808 that may be an example result of the process 708, showing a buffer layer 434 provided over the first face 190-1 and another buffer layer 434 provided over the second face 190-2. Using the buffer layers 434 over one or more of the faces 190 of the glass core 110 may be advantageous in terms of providing a separation between the conductive contacts 428 and the glass core 110 in an attempt to minimize CTE mismatch issues. In some embodiments, the buffer layer 434 may include an insulator material such as ABF, polyimide, or any other suitable dielectric material that can reduce the stress generated from the CTE mismatch between glass core and conductive contacts that are usually made of copper. These materials have a much lower modulus than copper and typically less than 60 GPa. In some embodiments, a thickness of the buffer layer 434 may be between about 5 microns and about 50 microns, e.g., between about 5 microns and about 35 microns, or between about 15 microns and about 35 microns.

Next, the method 700 may include a process 710, in which one or more openings may be formed in the buffer layer 434 to expose the conductive fill material 426 in the one or more TGVs 415 of the assembly 808. FIG. 8B illustrates an assembly 810 that may be an example result of the process 710, showing openings 438 in the buffer layer 434 at the opposite ends of the TGV openings 420. In some embodiments, the openings 438 may be formed using any suitable etching process, possibly in combination with any suitable patterning technique such as photolithographic or e-beam patterning.

The method 700 may further include a process 712, in which conductive contacts are formed at the ends of the openings 438 of the assembly 808 and a sealant is deposited to seal the liner material 422. FIG. 8C illustrates an assembly 812 that may be an example result of the process 712, showing a glass core 110 with conductive contacts 428 at the opposite ends of the openings 438 in the buffer layer 434, and further showing a layer of the sealant 430 deposited over the top and bottom surfaces of the assembly 812 after the conductive contacts 428 have been formed, enclosing the liner material 422 in the TGVs 415. The conductive contacts 428 may be formed in the process 712 using any suitable techniques as known in the art, as long as the conductive material(s) of the conductive contacts 428 is in conductive contact with the conductive fill material 426 of the TGVs 415, e.g., by virtue of filling the openings 438 with a conductive material. Descriptions of the sealant 430 provided with reference to the method 500 are applicable to the sealant 430 deposited in the process 712 and, therefore, for the sake of brevity, are not repeated.

The method 700 may further include a process 714 in which further layers are provided over the first face 190-1 and/or over the second face 190-2 of the glass core 110 of the assembly 812. FIG. 4B, described above, illustrates an example result of the process 714, showing further layers 432 provided over the first face 190-1 and over the second face 190-2 of the glass core 110. Descriptions of the further layers 432 provided with reference to the method 500 are applicable to the further layers 432 provided in the process 714 and, therefore, for the sake of brevity, are not repeated.

Similar to the method 500, performing the method 700 may result in several features characteristic of the use of the method 700. One such feature may be that, in some embodiments, a portion of the buffer layer 434 may be between the liner material 422 over a given face 190 of the glass core 110 and the sealant 430. An example of that may be seen within a dashed contour 820, shown in FIG. 8C. Another feature characteristic of the use of the method 700 may be that a portion of the buffer layer 434 may be in contact with a portion of the conductive contact 428. An example of that may be seen within a dashed contour 822, shown in FIG. 8C. Yet another feature characteristic of the use of the method 700 may be that a portion of the sealant 430 may be in contact with a portion of the buffer layer 434. An example of that may be seen within a dashed contour 824, shown in FIG. 8C. Because in the method 700 the sealant 430 is deposited after formation of the conductive contacts 428, similar to the method 500, in some embodiments, a portion of the sealant 430 may be on a sidewall of a conductive contact 428, e.g., as shown within a dashed contour 826, shown in FIG. 8C, while another portion of the sealant 430 may be on the top surface of a conductive contact 428, e.g., as shown within a dashed contour 828, shown in FIG. 8C.

Turning to the third method of providing a glass core with sealed liners, the method 900, shown in FIG. 9, may include processes 902, 904, and 906, which may be substantially the same as the processes 502, 504, and 506, respectively, described with reference to the method 500. For the sake of brevity, descriptions of these processes are not repeated and their illustrations at not shown in FIGS. 10A-10C. After the process 906, the method 900 may include a process 908, in which TGV metals deposited over the faces 190 during the TGV metallization of the process 906 may be planarized, and a first layer of a sealant may be provided over the first face 190-1 and/or the second face 190-2, followed by provision of a buffer layer over the first sealant. FIG. 10A illustrates an assembly 1008 that may be an example result of the process 908, showing a sealant 430 deposited over the first face 190-1 and the second face 190-2, and then providing a buffer layer 434 over the sealant 430. Descriptions of the buffer layers 434 provided with reference to the method 700 are applicable to the buffer layers 434 provided in the process 912 and, therefore, for the sake of brevity, are not repeated.

Next, the method 900 may include a process 910, in which one or more openings may be formed in the buffer layer 434 and the first layer of the sealant 430 to expose the conductive fill material 426 in the one or more TGVs 415 of the assembly 1008. FIG. 10B illustrates an assembly 1010 that may be an example result of the process 910, showing openings 440 in the buffer layer 434 and the first layer of the sealant 430 at the opposite ends of the TGV openings 420. In some embodiments, the openings 440 may be formed using any suitable etching process, possibly in combination with any suitable patterning technique such as photolithographic or e-beam patterning.

The method 900 may further include a process 912, in which conductive contacts are formed at the ends of the openings 440 of the assembly 1008 and a second layer of a sealant is deposited to seal the liner material 422. FIG. 10C illustrates an assembly 1012 that may be an example result of the process 912, showing a glass core 110 with conductive contacts 428 at the opposite ends of the openings 440 in the buffer layer 434, and further showing a second layer of the sealant 430 deposited over the top and bottom surfaces of the assembly 1012 after the conductive contacts 428 have been formed, enclosing the liner material 422 in the TGVs 415. The conductive contacts 428 may be formed in the process 912 using any suitable techniques as known in the art, as long as the conductive material(s) of the conductive contacts 428 is in conductive contact with the conductive fill material 426 of the TGVs 415, e.g., by virtue of filling the openings 440 with a conductive material. Descriptions of the sealant 430 provided with reference to the method 500 are applicable to the first layer of the sealant 430 deposited in the process 910 and the second layer of the sealant 430 deposited in the process 912 and, therefore, for the sake of brevity, are not repeated. In some embodiments, a material composition of the sealant 430 of the first layer (i.e., the one deposited in the process 910) may be different from a material composition of the sealant 430 of the second layer (i.e., the one deposited in the process 912). In other embodiments, these material compositions may be substantially the same.

The method 900 may further include a process 914 in which further layers are provided over the first face 190-1 and/or over the second face 190-2 of the glass core 110 of the assembly 1012. FIG. 4C, described above, illustrates an example result of the process 914, showing further layers 432 provided over the first face 190-1 and over the second face 190-2 of the glass core 110. Descriptions of the further layers 432 provided with reference to the method 500 are applicable to the further layers 432 provided in the process 914 and, therefore, for the sake of brevity, are not repeated.

Similar to the methods 500 and 700, performing the method 900 may result in several features characteristic of the use of the method 900. Some such features are the same as those shown within dashed contours 822, 824, 826, and 828, as explained with reference to FIG. 8C. Therefore, the dashed contours 822, 824, 826, and 828 are also shown in FIG. 10C. Another feature that was not present in FIG. 8C is that a sealant 430 (the sealant 430 of the first layer deposited in the process 910) is present between the buffer layer 434 and the liner material 422 over a given face 190 of the glass core 110. An example of that may be seen within a dashed contour 1020, shown in FIG. 10C. Similarly, one other feature is that a portion of the buffer layer 434 may be in contact with a portion of the first layer of the sealant 430, as is also seen within the dashed contour 1020, shown in FIG. 10C. A related feature characteristic of the use of the method 900 may be that a portion of the buffer layer 434 may be between the sealant 430 of the first layer and the sealant 430 of the second layer. An example of that may be seen within a dashed contour 1022, shown in FIG. 10C.

Various embodiments of conductive vias with sealed liners, described above may, advantageously, be easily fabricated in parallel with conventional manufacturing techniques for glass core substrates. Various arrangements of the microelectronic assemblies 100 and glass cores 110 as shown in FIGS. 1-10 do not represent an exhaustive set of microelectronic assemblies and glass cores in which one or more conductive vias with sealed liners as described herein may be implemented, but merely provide some illustrative examples. In particular, the number and positions of various elements shown in FIGS. 1-10 is purely illustrative and, in various other embodiments, other numbers of these elements, provided in other locations relative to one another may be used in accordance with the general architecture considerations described herein. For example, although not specifically shown in the present drawings, in some embodiments, a microelectronic assembly 100 may include a redistribution layer (RDL) between any pair of layers shown in FIG. 1 and FIG. 2, the RDL including a plurality of interconnect structures (e.g., conductive lines and conductive vias) to assist routing of signals and/or power between components. In another example, although also not specifically shown in the present drawings, in some embodiments, a package substrate 102 of a microelectronic assembly 100 may include one or more recesses. In such embodiments, a bottom face of a recess in the package substrate 102 may be provided by the solid material of the package substrate 102. A recess may be formed in a package substrate 102 in any suitable manner (e.g., via three-dimensional printing, laser cutting or drilling the recess into an existing package substrate, etc.). At least a portion of the substrate 107 or the glass core 110 may be positioned over or at least partially in such a recess. In yet another example, features of any one of FIGS. 1-10 may be combined with features of any other one of FIGS. 1-10. For example, in some embodiments, some portions of a glass core 110 may include one or more conductive vias with sealed liners fabricated using the method 500, while other portions of a glass core 110 may include one or more conductive vias with sealed liners fabricated using the method 700 and/or using the method 900.

The microelectronic assemblies 100 and/or the glass cores 110 disclosed herein, in particular the glass cores 110 with one or more conductive vias with sealed liners as described herein, may be included in any suitable electronic component. FIGS. 11-14 illustrate various examples of apparatuses that may include, or be included in, any of the microelectronic assemblies 100 and/or the glass cores 110 disclosed herein.

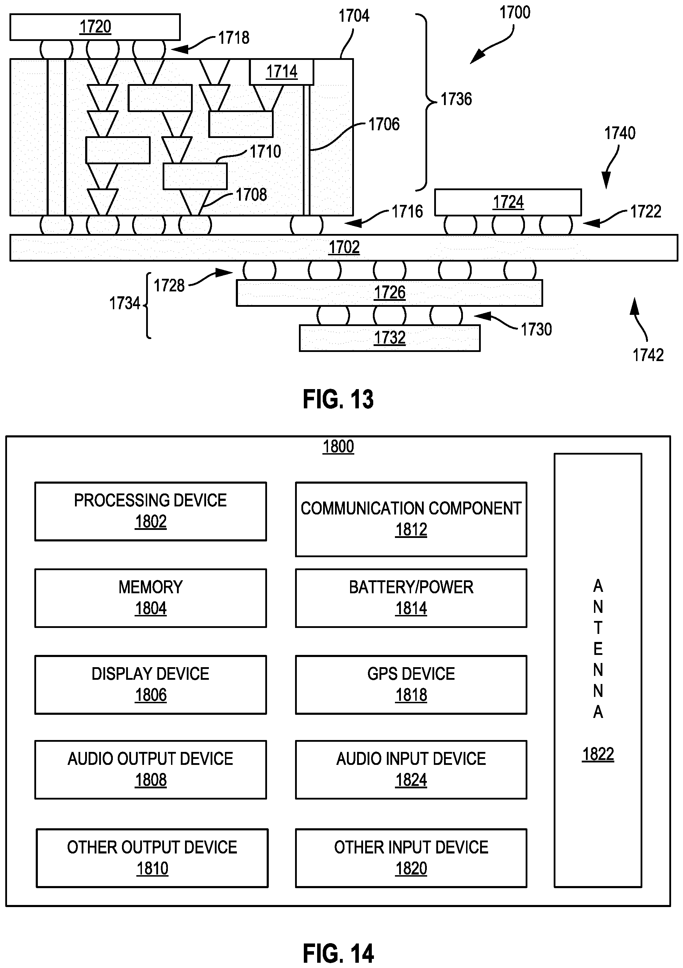

FIG. 11 is a top view of a wafer 1500 and dies 1502 that may be included in any of the microelectronic assemblies 100 as described herein. For example, a die 1502 may be any of the dies 114 described herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more transistors (e.g., some of the transistors 1640 of FIG. 12, discussed below) and/or supporting circuitry to route electrical signals to the transistors, as well as any other IC components. In some embodiments, the wafer 1500 or the die 1502 may include a memory device (e.g., a random-access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 14) or other logic that is configured to store information in the memory devices or execute instructions stored in the memory array.

FIG. 12 is a side, cross-sectional view of an IC device 1600 that may be included in any of the microelectronic assemblies 100 as described herein. For example, an IC device 1600 may be provided on/in any of the dies 114 described herein. The IC device 1600 may be formed on a substrate 1602 (e.g., the wafer 1500 of FIG. 11) and may be included in a die (e.g., the die 1502 of FIG. 11). The substrate 1602 may be a semiconductor substrate composed of semiconductor material systems including, for example, n-type or p-type materials systems (or a combination of both). The substrate 1602 may include, for example, a crystalline substrate formed using a bulk silicon or a silicon-on-insulator (SOI) substructure. In some embodiments, the substrate 1602 may be formed using alternative materials, which may or may not be combined with silicon, that include but are not limited to germanium, indium antimonide, lead telluride, indium arsenide, indium phosphide, gallium arsenide, or gallium antimonide. Further materials classified as group III-V materials (i.e., materials from groups III and V of the periodic system of elements), group II-VI (i.e., materials from groups II and IV of the periodic system of elements), or group IV materials (i.e., materials from group IV of the periodic system of elements) may also be used to form the substrate 1602. Although a few examples of materials from which the substrate 1602 may be formed are described here, any material that may serve as a foundation for an IC device 1600 may be used. The substrate 1602 may be part of a singulated die (e.g., the dies 1502 of FIG. 11) or a wafer (e.g., the wafer 1500 of FIG. 11).

The IC device 1600 may include one or more device layers 1604 disposed on the substrate 1602. The device layer 1604 may include features of one or more transistors 1640 (e.g., metal oxide semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 12 and may include a wide variety of other types and configurations such as, for example, planar transistors, non-planar transistors, or a combination of both. Planar transistors may include bipolar junction transistors (BJT), heterojunction bipolar transistors (HBT), or high-electron-mobility transistors (HEMT). Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 1640 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer. For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1640 along the source-channel-drain direction, the gate electrode may consist of a U-shaped structure that includes a bottom portion substantially parallel to the surface of the substrate and two sidewall portions that are substantially perpendicular to the top face of the substrate. In other embodiments, at least one of the metal layers that form the gate electrode may simply be a planar layer that is substantially parallel to the top face of the substrate and does not include sidewall portions substantially perpendicular to the top face of the substrate. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1620 may be formed within the substrate 1602 adjacent to the gate 1622 of each transistor 1640. The S/D regions 1620 may be formed using an implantation/diffusion process or an etching/deposition process, for example. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion-implantation process. In the latter process, the substrate 1602 may first be etched to form recesses at the locations of the S/D regions 1620. An epitaxial deposition process may then be carried out to fill the recesses with material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620.

Electrical signals, such as power and/or input/output (I/O) signals, may be routed to and/or from the devices (e.g., the transistors 1640) of the device layer 1604 through one or more interconnect layers disposed on the device layer 1604 (illustrated in FIG. 12 as interconnect layers 1606, 1608, and 1610). For example, electrically conductive features of the device layer 1604 (e.g., the gate 1622 and the S/D contacts 1624) may be electrically coupled with the interconnect structures 1628 of the interconnect layers 1606, 1608, and 1610. The one or more interconnect layers 1606, 1608, and 1610 may form a metallization stack (also referred to as an "ILD stack") 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 12). Although a particular number of interconnect layers 1606, 1608, and 1610 is depicted in FIG. 12, embodiments of the present disclosure include IC devices having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in a direction of a plane that is substantially parallel with a surface of the substrate 1602 upon which the device layer 1604 is formed. For example, the lines 1628a may route electrical signals in a direction in and out of the page from the perspective of FIG. 12. The vias 1628b may be arranged to route electrical signals in a direction of a plane that is substantially perpendicular to the surface of the substrate 1602 upon which the device layer 1604 is formed. In some embodiments, the vias 1628b may electrically couple lines 1628a of different interconnect layers 1606, 1608, and 1610 together.

The interconnect layers 1606, 1608, and 1610 may include a dielectric material 1626 disposed between the interconnect structures 1628, as shown in FIG. 12. In some embodiments, the dielectric material 1626 disposed between the interconnect structures 1628 in different ones of the interconnect layers 1606, 1608, and 1610 may have different compositions; in other embodiments, the composition of the dielectric material 1626 between different interconnect layers 1606, 1608, and 1610 may be the same.

A first interconnect layer 1606 may be formed above the device layer 1604. In some embodiments, the first interconnect layer 1606 may include lines 1628a and/or vias 1628b, as shown. The lines 1628a of the first interconnect layer 1606 may be coupled with contacts (e.g., the S/D contacts 1624) of the device layer 1604.

A second interconnect layer 1608 may be formed above the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual-damascene process) in some embodiments.

A third interconnect layer 1610 (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device layer 1604) may be thicker.

The IC device 1600 may include a solder resist material 1634 (e.g., polyimide or similar material) and one or more conductive contacts 1636 formed on the interconnect layers 1606, 1608, and 1610. In FIG. 12, the conductive contacts 1636 are illustrated as taking the form of bond pads. The conductive contacts 1636 may be electrically coupled with the interconnect structures 1628 and configured to route the electrical signals of the transistor(s) 1640 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606, 1608, and 1610; for example, the conductive contacts 1636 may include other analogous features (e.g., posts) that route the electrical signals to external components.

FIG. 13 is a side, cross-sectional view of an IC device assembly 1700 that may include a glass core with one or more sealer liners in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the microelectronic assemblies 100 discussed above, e.g., may include one or more microelectronic assemblies 100 as discussed with reference to FIG. 1 and FIG. 2, and/or may include one or more glass cores as discussed with reference to FIGS. 3-10.

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 13 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 13), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 13, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 5), an IC device (e.g., any of the IC devices described herein, or any combination of such IC devices), or any other suitable component. Generally, the package interposer 1704 may spread a connection to a wider pitch or reroute a connection to a different connection. For example, the package interposer 1704 may couple the IC package 1720 (e.g., a die) to a set of ball grid array (BGA) conductive contacts of the coupling components 1716 for coupling to the circuit board 1702. In the embodiment illustrated in FIG. 13, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a glass core with one or more sealer liners as described herein, e.g., as any embodiment of the glass core 110, described herein. In some embodiments, the package interposer 1704 may be formed as a PCB. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. In any of these embodiments, the package interposer 1704 may include multiple metal layers separated from one another by layers of dielectric material and interconnected by electrically conductive vias. The package interposer 1704 may include metal lines 1710 and vias 1708, including but not limited to conductive vias 1706. If the package interposer 1704 is a glass core, e.g., the glass core 110 as described herein, then the conductive vias 1706 may be TGVs 115 as described herein, e.g., conductive vias with sealed liners as described herein. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 13 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 14 is a block diagram of an example communication device 1800 that may include one or more microelectronic assemblies 100 and/or one or more glass cores 110 in accordance with any of the embodiments disclosed herein. A handheld communication device or a laptop communication device may be examples of the communication device 1800. Any suitable ones of the components of the communication device 1800 may include one or more of the microelectronic assemblies 100, IC packages 1720, 1724, IC device assemblies 1700, IC devices 1600, or dies 1502 disclosed herein. In particular, any suitable ones of the components of the communication device 1800 may include one or more glass cores 110 as described herein, e.g., as a part of a microelectronic assembly 100 as described herein. A number of components are illustrated in FIG. 14 as included in the communication device 1800, but any one or more of these components may be omitted or duplicated, as suitable for the application. In some embodiments, some or all of the components included in the communication device 1800 may be attached to one or more motherboards. In some embodiments, some or all of these components are fabricated onto a single system-on-a-chip (SoC) die.

Additionally, in various embodiments, the communication device 1800 may not include one or more of the components illustrated in FIG. 14, but the communication device 1800 may include interface circuitry for coupling to the one or more components. For example, the communication device 1800 may not include a display device 1806, but may include display device interface circuitry (e.g., a connector and driver circuitry) to which a display device 1806 may be coupled. In another set of examples, the communication device 1800 may not include an audio input device 1824 or an audio output device 1808, but may include audio input or output device interface circuitry (e.g., connectors and supporting circuitry) to which an audio input device 1824 or audio output device 1808 may be coupled.

The communication device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The communication device 1800 may include a memory 1804, which may itself include one or more memory devices such as volatile memory (e.g., dynamic RAM (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded DRAM (eDRAM) or spin transfer torque magnetic RAM (STT-MRAM).

In some embodiments, the communication device 1800 may include a communication module 1812 (e.g., one or more communication modules). For example, the communication module 1812 may be configured for managing wireless communications for the transfer of data to and from the communication device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not. The communication module 1812 may be, or may include, any of the microelectronic assemblies 100 disclosed herein.

The communication module 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication module 1812 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication module 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication module 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication module 1812 may operate in accordance with other wireless protocols in other embodiments. The communication device 1800 may include an antenna 1822 to facilitate wireless communications and/or to receive other wireless communications (such as AM or FM radio transmissions). The antenna 1822 may include one or more microelectronic assemblies 100 and/or one or more glass cores 110 as described herein, e.g., as a part of a microelectronic assembly 100 as described herein.

In some embodiments, the communication module 1812 may manage wired communications, such as electrical, optical, or any other suitable communication protocols (e.g., the Ethernet). As noted above, the communication module 1812 may include multiple communication modules. For instance, a first communication module 1812 may be dedicated to shorter-range wireless communications such as Wi-Fi or Bluetooth, and a second communication module 1812 may be dedicated to longer-range wireless communications such as global positioning system (GPS), EDGE, GPRS, CDMA, WiMAX, LTE, EV-DO, or others. In some embodiments, a first communication module 1812 may be dedicated to wireless communications, and a second communication module 1812 may be dedicated to wired communications. In some embodiments, the communication module 1812 may support millimeter wave communication.

The communication device 1800 may include battery/power circuitry 1814. The battery/power circuitry 1814 may include one or more energy storage devices (e.g., batteries or capacitors) and/or circuitry for coupling components of the communication device 1800 to an energy source separate from the communication device 1800 (e.g., AC line power).

The communication device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The communication device 1800 may include an audio output device 1808 (or corresponding interface circuitry, as discussed above). The audio output device 1808 may include any device that generates an audible indicator, such as speakers, headsets, or earbuds.

The communication device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The communication device 1800 may include a GPS device 1818 (or corresponding interface circuitry, as discussed above). The GPS device 1818 may be in communication with a satellite-based system and may receive a location of the communication device 1800, as known in the art.

The communication device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The communication device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The communication device 1800 may have any desired form factor, such as a handheld or mobile communication device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop communication device, a server or other networked computing component, a printer, a scanner, a monitor, a set-top box, an entertainment control unit, a vehicle control unit, a digital camera, a digital video recorder, or a wearable communication device. In some embodiments, the communication device 1800 may be any other electronic device that processes data.

The following paragraphs provide examples of various ones of the embodiments disclosed herein.

Example 1 provides a microelectronic assembly, including a glass core (e.g., a layer of glass, e.g., a layer of glass including a substantially rectangular prism volume, possibly with rounded or beveled edges) having a first face and a second face opposite the first face; a TGV in the glass core, the TGV extending from the first face towards the second face (the TGV may at least partially extend through the glass core, i.e., in some embodiments, the TGV may extend all the way to the second face, while, in other embodiments, the TGV may be a blind via that does not reach the second face) and including a conductive material; a liner material (or, more generally, an organic material) in the TGV, between the conductive material and the glass core, where a modulus (e.g., a Young's modulus) of the liner material is smaller than about 30 GPa, e.g., between about 1 GPa and 30 GPa; and a sealant (or, more generally, an inorganic material) over the liner material in the TGV, the sealant including silicon and nitrogen, where the glass core, the conductive material, and the sealant completely enclose the liner material as to reduce or eliminate degradation (oxidation and/or crystallization) of the liner material.

Example 2 provides the microelectronic assembly according to example 1, where the liner material includes/is a polymer material.

Example 3 provides the microelectronic assembly according to examples 1 or 2, where the liner material includes/is a homopolymer.

Example 4 provides the microelectronic assembly according to any one of the preceding examples, where the liner material includes/is poly-para-xylylene.

Example 5 provides the microelectronic assembly according to any one of the preceding examples, where a thickness of the liner material is between about 200 nanometers and about 10 microns, e.g., between about 200 nanometers and about 5 microns, or between about 500 nanometers and about 1 micron.

Example 6 provides the microelectronic assembly according to any one of the preceding examples, where a portion of the liner material is in contact (e.g., in direct physical contact) with a sidewall of the TGV (e.g., in contact with the glass core at the sidewall of the TGV).

Example 7 provides the microelectronic assembly according to any one of the preceding examples, further including the liner material over the first face of the glass core, where the liner material over the first face of the glass core is materially continuous with the liner material in the TGV.

Example 8 provides the microelectronic assembly according to example 7, where a portion of the sealant is in contact (e.g., in direct physical contact) with a portion of the first face of the glass core.

Example 9 provides the microelectronic assembly according to example 7, where a portion of the liner material over the first face of the glass core is in contact (e.g., in direct physical contact) with a portion of the sealant.

Example 10 provides the microelectronic assembly according to examples 7 or 9, where a portion of the liner material over the first face of the glass core is in contact (e.g., in direct physical contact) with a portion of the first face of the glass core.

Example 11 provides the microelectronic assembly according to any one of examples 7-10, further including a conductive contact over the first face, where the conductive material of the TGV is in conductive contact with a conductive material of the conductive contact, and where a portion of the sealant is on a sidewall of the conductive contact.

Example 12 provides the microelectronic assembly according to example 11, where a further portion of the sealant is on a surface of the conductive contact that is farthest away from the first face.

Example 13 provides the microelectronic assembly according to example 7, further including a buffer layer over the first face of the glass core, where the buffer layer is between the liner material over the first face of the glass core and the sealant.

Example 14 provides the microelectronic assembly according to example 13, further including a conductive contact over the buffer layer, where the conductive material of the TGV is in conductive contact with a conductive material of the conductive contact, and where a portion of the sealant is on a sidewall of the conductive contact.

Example 15 provides the microelectronic assembly according to example 14, where a further portion of the sealant is on a surface of the conductive contact that is farthest away from the first face.

Example 16 provides the microelectronic assembly according to examples 14 or 15, where a portion of the buffer layer is in contact (e.g., in direct physical contact) with a portion of the conductive contact.

Example 17 provides the microelectronic assembly according to any one of examples 13-16, where a portion of the sealant is in contact (e.g., in direct physical contact) with a portion of the buffer layer.

Example 18 provides the microelectronic assembly according to any one of examples 7-17, where: the sealant is a first sealant, the microelectronic assembly further includes a second sealant, the second sealant includes silicon and nitrogen, and the second sealant is between the buffer layer and the liner material over the first face of the glass core.

Example 19 provides the microelectronic assembly according to example 18, where a portion of the buffer layer is in contact (e.g., in direct physical contact) with a portion of the second sealant.

Example 20 provides the microelectronic assembly according to examples 18 or 19, where the buffer layer is between the first sealant and the second sealant.

Example 21 provides a microelectronic assembly, including a glass core having a first face and a second face opposite the first face, and including a conductive via extending from the first face towards the second face (the via may at least partially extend through the glass core, i.e., in some embodiments, the via may extend all the way to the second face, while, in other embodiments, the via may be a blind via that does not reach the second face); an organic material in the conductive via, where the organic material is on a sidewall of the conductive via, between a conductive material of the conductive via and the glass core, and; and an inorganic material enclosing the organic material in the conductive via.

Example 22 provides the microelectronic assembly according to example 21, where a modulus (e.g., a Young's modulus) of the organic material is smaller than a modulus (e.g., a Young's modulus) of the glass core.

Example 23 provides the microelectronic assembly according to examples 21 or 22, where a modulus (e.g., a Young's modulus) of the organic material is smaller than a modulus (e.g., a Young's modulus) of the conductive material of the conductive via.

Example 24 provides the microelectronic assembly according to any one of examples 21-23, where the organic material includes/is an organic polymer, e.g., an organic homopolymer.

Example 25 provides the microelectronic assembly according to any one of examples 21-24, where the organic material includes/is poly-para-xylylene (which is also commonly referred to as "parylene").

Example 26 provides the microelectronic assembly according to any one of examples 21-25, where the organic material includes/is parylene N, parylene C, parylene D, or parafree.

Example 27 provides the microelectronic assembly according to any one of examples 21-26, where a thickness of the organic material is between about 200 nanometers and about 10 microns, e.g., between about 200 nanometers and about 5 microns, or between about 500 nanometers and about 1 micron.

Example 28 provides the microelectronic assembly according to any one of examples 21-27, where the inorganic material includes silicon and nitrogen.

Example 29 provides the microelectronic assembly according to any one of examples 21-28, where the inorganic material includes a material to reduce or eliminate oxidation of the organic material.

Example 30 provides the microelectronic assembly according to any one of examples 21-29, where the inorganic material includes a material to reduce or eliminate crystallization of the organic material. 31. The microelectronic assembly according to any one of claims 21-30, where the organic material is the liner material and the inorganic material is the sealant according to any one of claims 7-20.

Example 32 provides the microelectronic assembly according to any one of the preceding examples, where a cross-section of the glass core in a plane perpendicular to a surface of the component is substantially rectangular.

Example 33 provides the microelectronic assembly according to any one of the preceding examples, where a cross-section of the glass core in a plane parallel to a surface of the component is substantially rectangular.

Example 34 provides the microelectronic assembly according to any one of the preceding examples, where the glass core is a layer of glass including at least 23% silicon by weight.

Example 35 provides the microelectronic assembly according to any one of the preceding examples, where the glass core is a layer of glass including at least 26% oxygen by weight.

Example 36 provides the microelectronic assembly according to any one of the preceding examples, where the glass core is a layer of glass including at least 23% silicon by weight and at least 26% oxygen by weight.

Example 37 provides the microelectronic assembly according to any one of the preceding examples, where the glass core is a layer of glass including at least 5% aluminum by weight.

Example 38 provides the microelectronic assembly according to any one of the preceding examples, where the glass core is a layer of glass that does not include an organic adhesive or an organic material.

Example 39 provides the microelectronic assembly according to any one of the preceding examples, where the glass core is a layer of glass having a thickness in a range of 50 micron (um) to 1.4 millimeters (mm), a first length in a range of 10 mm to 250 mm, and a second length in a range of 10 mm to 250 mm, the first length perpendicular to the second length.

Example 40 provides the microelectronic assembly according to any one of the preceding examples, where the glass core is a layer of glass having a thickness in a range of 50 um to 1.4 mm.

Example 41 provides the microelectronic assembly according to any one of the preceding examples, where the glass core is a layer of glass having a first length in a range of 10 mm to 250 mm, and a second length in a range of 10 mm to 250 mm, the first length perpendicular to the second length.

Example 42 provides the microelectronic assembly according to any one of the preceding examples, where the glass core is a layer of glass including a rectangular prism volume.

Example 43 provides the microelectronic assembly according to any one of the preceding examples, where the glass core is a layer of glass including a rectangular prism volume having a first side and a second side perpendicular to the first side, the first side having a length in a range of 10 mm to 250 mm and the second side having a length in a range of 10 mm to 250 mm.

Example 44 provides the microelectronic assembly according to any one of the preceding examples, where the glass core is a layer of glass including a rectangular prism volume and a via extending from a first side of the rectangular prism volume to a second side of the rectangular prism volume, the via including a metal.

Example 45 provides the microelectronic assembly according to any one of the preceding examples, where the glass core is a solid layer of glass. 46. The microelectronic assembly according to any one of the preceding claims, where the conductive material is a metal or a metal alloy. 47. The microelectronic assembly according to any one of the preceding claims, where the conductive material includes one or more of copper, silver, nickel, gold, or aluminum.

Example 48 provides a method of fabricating a microelectronic assembly, the method including depositing an organic material on a sidewall of a via opening in a glass core, where the glass core has a first face and a second face opposite the first face, and where the via opening extends from the first face towards the second face; depositing a seed material over the organic material on the sidewall of the via opening, where the organic material is between the sidewall of the via opening and the seed material; depositing a conductive fill material in the via opening, where the seed material is between the organic material and the conductive fill material; forming a conductive contact at the first face of the glass core, over the via opening, where the conductive contact is electrically continuous with the conductive fill material in the via opening; and depositing a sealant over the conductive contact and over the first face of the glass core.

Example 49 provides the method according to example 48, where depositing the organic material includes depositing the organic material using CVD.

Example 50 provides the method according to examples 48 or 49, where the organic material as deposited as a liner that is conformal to the sidewall of the via opening.

Example 51 provides the method according to any one of examples 48-50, where depositing the conductive fill material includes depositing the conductive fill material using electroplating.

Example 52 provides the method according to any one of examples 48-51, further including providing one or more build-up layers over the sealant.

Example 53 provides the method according to any one of examples 48-52, where the microelectronic assembly is a microelectronic assembly according to any one of claims 1-47.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. A microelectronic assembly, comprising:
a layer of glass having a first face and a second face opposite the first face;
a through-glass via (TGV) in the layer of glass, the TGV extending from the first face towards the second face and comprising a conductive material;
an organic material in the TGV, between the conductive material and the layer of glass, wherein a modulus of the organic material is smaller than about 30 gigopascal; and
an inorganic material over the organic material in the TGV, the inorganic material comprising silicon and nitrogen.

2. The microelectronic assembly according to claim 1, wherein the organic material includes a homopolymer.

3. The microelectronic assembly according to claims 1 or 2, wherein the organic material includes poly-para-xylylene.

4. The microelectronic assembly according to any one of claims 1-3, further comprising the organic material over the first face of the layer of glass, wherein the organic material over the first face of the layer of glass is materially continuous with the organic material in the TGV.

5. The microelectronic assembly according to claim 4, wherein a portion of the inorganic material is in contact with a portion of the first face of the layer of glass or a portion of the organic material over the first face of the layer of glass is in contact with a portion of the inorganic material.

6. The microelectronic assembly according to claim 4 or 5, wherein a portion of the organic material over the first face of the layer of glass is in contact with a portion of the first face of the layer of glass.

7. The microelectronic assembly according to any one of claims 4-6, further comprising a conductive contact over the first face, wherein the conductive material of the TGV is in conductive contact with a conductive material of the conductive contact, and wherein a portion of the inorganic material is on a sidewall of the conductive contact.

8. The microelectronic assembly according to claim 7, wherein a further portion of the inorganic material is on a surface of the conductive contact that is farthest away from the first face.

9. The microelectronic assembly according to claim 4, further comprising a buffer layer over the first face of the layer of glass, wherein the buffer layer is between the organic material over the first face of the layer of glass and the inorganic material.

10. The microelectronic assembly according to claim 9, further comprising a conductive contact over the buffer layer, wherein the conductive material of the TGV is in conductive contact with a conductive material of the conductive contact, and wherein a portion of the inorganic material is on a sidewall of the conductive contact.

11. The microelectronic assembly according to claim 9 or 10, wherein:
the inorganic material is a first inorganic material,
the microelectronic assembly further includes a second inorganic material,
the second inorganic material includes silicon and nitrogen, and
the second inorganic material is between the buffer layer and the organic material over the first face of the layer of glass.

12. A microelectronic assembly, comprising:
a glass core having a first face and a second face opposite the first face, and comprising a conductive via extending from the first face towards the second face;
a liner material in the conductive via, wherein the liner material is on a sidewall of the conductive via, between a conductive material of the conductive via and the glass core, and wherein a thickness of the liner material is between about 200 nanometers and about 10 microns; and
a sealant enclosing the liner material in the conductive via.

13. The microelectronic assembly according to claim 12, wherein a modulus of the liner material is smaller than a modulus of the glass core, the liner material includes an organic polymer, and the sealant includes silicon and nitrogen.

14. A method of fabricating a microelectronic assembly, the method comprising:
depositing an organic material on a sidewall of a via opening in a glass core, wherein the glass core has a first face and a second face opposite the first face, and wherein the via opening extends from the first face towards the second face;
depositing a seed material over the organic material on the sidewall of the via opening, wherein the organic material is between the sidewall of the via opening and the seed material;
depositing a conductive fill material in the via opening, wherein the seed material is between the organic material and the conductive fill material;
forming a conductive contact at the first face of the glass core, over the via opening, wherein the conductive contact is electrically continuous with the conductive fill material in the via opening; and
depositing a sealant over the conductive contact and over the first face of the glass core.

15. The method according to claim 14, wherein the organic material as deposited as a liner that is conformal to the sidewall of the via opening.
